# EUROPÄISCHE PATENTSCHRIFT

(11) **EP 0 652 982 B1**
(45) Veröffentlichungstag und Bekanntmachung des Hinweises auf die Patenterteilung: **25.09.1996**
(21) Anmeldenummer: 94906783.9
(22) Anmeldetag: 02.08.1993
(51) Int. Cl.: C25D 5/22, C25D 5/08, C25D 5/06, C25D 7/06

(54) **VERFAHREN ZUM ELEKTROLYTISCHEN BEHANDELN VON INSBESONDERE FLACHEM BEHANDLUNGSGUT, SOWIE ANORDNUNG, INSBESONDERE ZUR DURCHFÜHRUNG DIESES VERFAHRENS**
PROCESS FOR THE ELECTROLYTIC PROCESSING ESPECIALLY OF FLAT ITEMS AND ARRANGEMENT FOR IMPLEMENTING THE PROCESS
PROCEDE ET DISPOSITIF DE TRAITEMENT ELECTROLYTIQUE D'ARTICLES PARTICULIEREMENT PLATS

(30) Priorität: 01.08.1992 DE 4225541; 20.07.1993 DE 4324330
(43) Veröffentlichungstag der Anmeldung: 17.05.1995
(73) Patentinhaber: ATOTECH Deutschland GmbH, D-10553 Berlin (DE)
(72) Erfinder: SCHNEIDER, Reinhard, D-90556 Cadolzburg (DE); SCHRÖDER, Rolf, D-90559 Burgthann (DE); WOLFER, Klaus, D-71032 Böblingen (DE); KOSIKOWSKI, Thomas, D-90559 Burgthann (DE)
(74) Vertreter: Effert, Udo, Dipl.-Ing.
(86) Internationale Anmeldenummer: DE9300684
(87) Internationale Veröffentlichungsnummer: WO9403655

(56) Entgegenhaltungen:
- EP-A- 0 210 072
- EP-A- 0 534 269
- AT-A- 305 719
- CH-A- 421 654
- DE-A- 1 446 045
- DE-A- 3 525 342
- FR-A- 667 687
- US-A- 3 706 650
- US-A- 4 875 982
- METALLOBERFLÄCHE Bd. 36, Nr. 2 , Februar 1982 , MÜNCHEN Seiten 70 - 75 B. MEUTHEN UND D. WOLFHARD 'ELEKTROLYTISCHE HOCHLEISTUNGSVERZINKUNG VON STAHLBAND DURCH MECHANISCHE GRENZSCHICHTBEEINFLUSSUNG'
- PATENT ABSTRACTS OF JAPAN vol. 007, no. 053 (C-154)3. März 1983 & JP,A,57 200 591 (NIHON EREKUTOROPUREITEINGU ENGINEERS KK) 8. Dezember 1982
- DATABASE WPI Derwent Publications Ltd., London, GB; AN 87-133203 & JP,A,62 074 096 (KAWASAKI STEEL CORP.) 4. April 1987

## Beschreibung

Die Erfindung betrifft zunächst ein Verfahren zum elektrolytischen Behandeln von mit Bohrlöchern versehenen Leiterplatten, die von Transportmitteln durch ein Behandlungsbad hindurchbewegt oder zu einer Behandlungsstation geführt werden, wobei Mittel zur Reduzierung der Dicke einer an Metallionen verarmten Zone (Diffusionsschicht) vorgesehen sind, die sich im Kontakt mit den Leiterplatten befinden. Das bevorzugte Einsatzgebiet der Erfindung ist das Galvanisieren, auf das anschließend auch näher eingegangen wird. Die Erfindung ist auch einsetzbar beim elektrolytischen Ätzen.

Die Oberfläche des Behandlungsgutes bzw. deren Diffusionsschicht verarmt nachteiligerweise beim Behandlungsvorgang an Metallionen, da die Kathode mehr an Ionen an sich zieht, als üblicherweise aus dem umgebenden Behandlungsbad nachkommt. Dies führt zu einer Reduzierung der zulässigen spezifischen Stromdichte und damit dazu, daß für die Erzielung eines solchen Metallauftrages bestimmter Dicke entsprechend viel an Behandlungszeit benötigt wird.

Um diesem Nachteil abzuhelfen, kennt man das sogenannte "high speed"-Verfahren, bei dem der Elektrolyt mit großer Geschwindigkeit und Menge entlang der Kathodenoberfläche zwischen dieser und der Anode hindurchgeführt wird (siehe z.B. europäische Patentschrift 0 142 010 und deutsche Patentschrift 35 25 183). Hiermit wird zwar eine verbesserte, d.h. erhöhte, Stromdichte des Metallauftrages auf der kathodischen Ware erreicht. Jedoch ist die Erzeugung, Beherrschung und Ableitung eines solchen Elektrolytstromes relativ aufwendig. Die Schaffung der hierfür notwendigen Strömungskanäle erfordert nämlich zusätzliche konstruktive Aufwendungen. Außerdem kann sich die Art und Weise der Führung des Behandlungsgutes kompliziert gestalten. Sie ist deshalb auch nur für endloses Behandlungsgut, wie Bänder oder Drähte, bekannt geworden.

In dem Fachartikel "Elektrolytische Hochleistungsverzinkung von Stahlband durch mechanische Grenzschichtbeeinflussung" von D. Meuthen und D. Wolfhard in "Metalloberfläche 36" (1982, 70 - 75) wird ein Verfahren zur elektrolytischen Verzinkung von Stahlband beschrieben, bei dem die zu verzinkenden Bandoberflächen gegen ein Kunststoff-Faservlies ähnlich dem sogenannten Tampon- oder Bürstgalvanisierverfahren gedrückt und relativ zu diesem bewegt werden. Der Beschichtungselektrolyt wird durch das Faservlies hindurch auf die Stahloberfläche gespült. Durch dieses Verfahren wird eine höhere Stromdichte beim elektrolytischen Zinkabscheiden erreicht.

Ein ähnliches Prinzip wird auch bei der europäischen Patentanmeldung 0 210 072 für die elektrolytische Beschichtung von kleinen Metallteilen, die insbesondere für die Anwendung als Steckverbinder mit Edelmetallen beschichtet werden, beschrieben.

Aus dem US-Patent 3 706 650 ist ferner ein Verfahren zum Beschichten von Oberflächen bekannt, bei dem nichtleitende, flüssigkeitsspeichernde, poröse, kompressible Mittel gegen die zu beschichtenden Oberflächen gedrückt und relativ zu diesen bewegt werden, wobei sich die Gegenelektrode zu dem zu beschichtenden Gegenstand im Inneren der Mittel befindet. Die Elektrolytflüssigkeit wird von außen an die Berührungsflächen zwischen dem porösen, kompressiblen Mittel und den zu beschichtenden Oberflächen angeströmt. Das poröse, kompressible Mittel enthält ferner harte nichtleitende Partikel, die die zu beschichtenden Oberflächen des metallischen Werkstückes etwas aufrauhen.

In der deutschen Offenlegungsschrift 14 46 045 wird ein Verfahren zum Galvanisieren bei gleichzeitigem elektrolytischen Reinigen von Metalloberflächen und eine Vorrichtung zur Durchführung dieses Verfahrens offenbart. Hierbei handelt es sich um die Beschichtung großer Bohrlöcher in Stahl mit Hilfe einer Innenelektrode, deren Außenflächen an den Innenflächen der Bohrlöcher gerieben werden.

Aus DE-OS 36 03 856 sind ein Verfahren und eine Vorrichtung zur Galvanisierung von ebenen Werkstücken wie Leiterplatten bekannt. Die plattenförmigen Werkstücke werden von einem kathodisch geschalteten, mit relativ langsamer Umdrehungsgeschwindigkeit rotierenden Walzenpaar erfaßt und transportiert. Der Elektrolyt wird von einem anodisch geschalteten Walzenpaar, dessen Oberfläche Flüssigkeit aufnehmen kann, auf das Werkstück übertragen. Dabei wird bewußt ein geringer Abstand zwischen Werkstückoberfläche und Oberfläche der anodischen Walzen eingehalten. Die Umdrehungsgeschwindigkeit der anodischen Walzen ist relativ hoch, um eine entsprechend schnelle Elektrolytbewegung entlang der Oberfläche des Werkstückes zu erreichen. Hiermit soll eine Erhöhung der Stromdichte gegenüber einer herkömmlichen Tauchbadgalvanisierung erreicht werden. Es werden also rotierende unlösliche Walzenpaare als Anoden beschrieben. Das Metall wird über den Elektrolyten gelöst zugeführt. Die Anodenwalzenpaare befinden sich nicht unter Badspiegel, deshalb muß der Elektrolyt laufend an die Galvanisierstelle herangebracht werden. Die hier zuführbare Elektrolytmenge ist begrenzt, nicht zuletzt wegen der engen Kunststoffabschirmungen über den Walzen. Durch diese Begrenzung ist auch die mögliche Galvanisierstromdichte begrenzt. Die Kunststoffabschirmungen sind aber nötig, um ein unerwünschtes Galvanisieren der kathodisch geschalteten weiteren Walzenpaare, die dem Transport der Leiterplatten dienen, zu verzögern.

Weil die rotierenden anodischen Walzenpaare die Leiterplattenoberseiten nicht berühren, wird die an der Oberfläche befindliche Diffusionsschicht nicht mechanisch gestört. Der Abstand der anodischen Walzen von der Leiterplattenoberseite und damit des Paares voneinander ist jedoch nötig, um die Galvanisierströme für beide Plattenseiten individuell einstellen zu können. Beim Galvanisieren des Leiterbahnbildes ist dies immer erforderlich, denn beide Plattenseiten werden in der Praxis ungleichmäßige Kupferflächen aufweisen. Aus diesem Grunde werden die Anoden der Leiterplattenoberseite von einem Badstromgleichrichter gespeist und die Anoden der Unterseite von einem anderen Gleichrichter. Jeder Gleichrichter ist im Strom individuell einstellbar.

Ein weiterer Nachteil der genannten Erfindung ist die sehr schlechte Druchströmung von feinen Löchern in den Leiterplatten. An sich gegenüberliegenden Plattenseiten wird nahezu drucklos Elektrolyt in geringer Menge herangeführt. Dies verhindert die Lochdurchströmung, was eine unzureichende Galvanisierung der Lochwandungen bis hin zu Anbrennungen in den Löchern zur Folge hat.

Der Erfindung liegt das Problem zugrunde, ein gattungsgemäßes Verfahren so zu gestalten, daß die erwünschte Reduzierung der Dicke der an Ionen verarmten Grenzschicht auf der Anoden- bzw. Kathodenoberfläche (Diffusionsschicht) und damit eine entsprechend erhöhte Stromdichte des aus dem Elektrolyten auf die anodische bzw. kathodische Ware fließenden Galvanisierstromes erreicht wird, wobei aber die verfahrensmäßigen und konstruktiven Aufwendungen der sogenannten "high speed" Strömungstechnik vermieden sind.

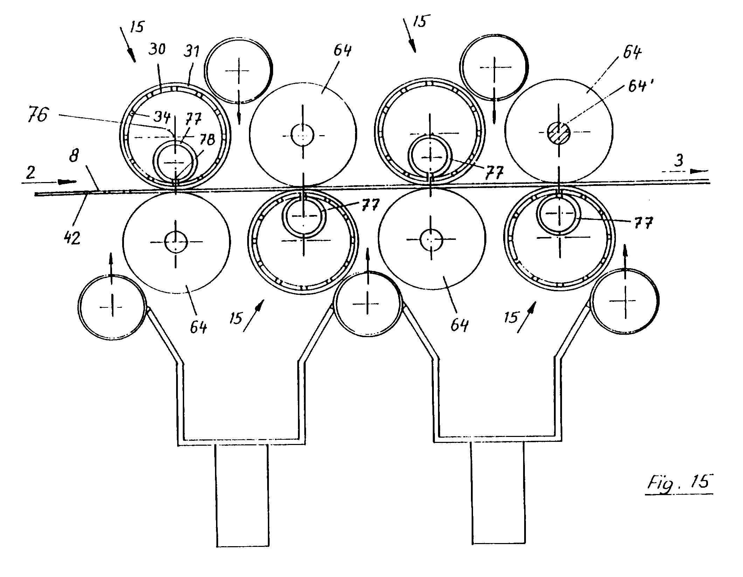

Die Lösung dieser Aufgaben- bzw. Problemstellung wird zunächst ausgehend vom gattungsgemäßen Stand der Technik darin gesehen, daß bei Vorhandensein einer Anode und eines kathodischen Behandlungsgutes, oder Vorhandensein eines anodischen Behandlungsgutes und einer Kathode die zu behandelnde Fläche des Gutes kontinuierlich und maschinell gewischt wird und daß der Elektrolyt mit einer zur Ebene des Behandlungsgutes senkrechten Bewegungskomponente bewegt und durch dessen Bohrungen oder Bohrlöcher (im folgenden der Einfachheit halber nur noch "Bohrlöcher" genannt) hindurch geleitet wird. Durch ein solches Wischen der betreffenden Fläche oder Flächen wird in einer einfachen und vorteilhaften, sowie industriell durchzuführenden Weise der nachteiligen Verarmung der Diffusionsschicht an Metallionen entgegengewirkt. Es wird die Diffusionsschicht weitgehend zerstört und damit die ionenarme Zone an der betreffenden Oberfläche, oder den betreffenden Oberflächen ganz oder zumindest überwiegend beseitigt. Die Metallionen des Elektrolyten können somit direkt an die Oberfläche des betreffenden Gutes gelangen bzw. beim Ätzen davon entfernt werden. Hinsichtlich weiterer Vorteile wird auf die nachfolgenden Erläuterungen der verschiedenen Ausführungsmöglichkeiten der Erfindung, und zwar sowohl in verfahrensmäßiger, als auch in gegenständlicher Hinsicht verwiesen. Durch die erfindungsgemäße Kombination des vorgenannten Wischens und der hierdurch erzielten Metallisierung der Oberflächen mit der Metallisierung der Innenwand der Bohrlöcher aufgrund des Hindurchleitens des Elektrolyten durch die Bohrlöcher wird zugleich eine hinreichende Behandlung der Innenwand der Bohrlöcher erreicht und somit in einem Arbeitsgang bei zufriedenstellendem Ergebnis und mit relativ einfachen Maßnahmen die Metallisierung des Behandlungsgutes an allen erforderlichen Bereichen (Oberflächen und Bohrlöchern) erreicht. Die vorgenannte Kombination hat in dem Zusammenhang den Vorteil, daß durch den Wischvorgang eine etwa vorhandene Oberflächenspannung an der in den Bohrlöchern befindlichen Flüssigkeit gestört wird, was die Metallisierung der Bohrlöcherinnenwand weiter erleichtert. Wie die Ausführungsbeispiele dieser Erfindung zeigen, lassen sich die baulichen Mittel für das Wischen einerseits und das Hindurchführen des Elektrolyten durch die Bohrlöcher (sogenanntes Fluten) andererseits in einfacher und zugleich raumsparender Weise miteinander vorsehen, in bevorzugter Ausführung der Erfindung sogar miteinander kombinieren. Hierzu wird beispielsweise auf die Ausführung nach Fig. 15 verwiesen. Ein weiterer Vorteil besteht darin, daß mit dem vorgenannten Fluten - insbesondere wenn dies noch durch die Unterstützung eines Hineindrückens des Elektrolyten, z.B. mittels einer Pumpe, in die Bohrlöcher und/oder eines Heraussaugens des Elektrolyten aus den Bohrlöchern mittels einer Saugvorrichtung geschieht - etwa noch in den Bohrlöchern vorhandene Partikel aus den Bohrlöchern herausgebracht und wegtransportiert werden können. Hiermit ist die Gefahr vermieden, daß die sich in den Bohrlöchern verfangenen Partikel durch die Metallisierung eingebettet werden und das betreffende Bohrloch verstopft wird, was zum Ausschuß der betreffenden Platte führt.

Ferner ist in dem Zusammenhang die Gefahr vermieden, daß noch am Rand der Bohrlöcher haftende Abrieb- oder Spanteilchen von den Wischüberzügen erfaßt und entlang der Oberfläche des Behandlungsgutes transportiert werden, wodurch die sehr empfindliche Oberfläche des Behandlungsgutes beschädigt und damit sogar unbrauchbar werden kann.

Eine ergänzende Lösung der Aufgabe stellt ein Verfahren dar, bei dem eine entsprechende Relativbewegung zwischen dem kathodischen oder anodischen Behandlungsgut einerseits und einer anodenseitigen oder kathodenseitigen Wischvorrichtung andererseits die erfindungsgemäße Wirkung erzielt.

Für die Erzielung dieser Relativbewegung kann die Transportbewegung des Behandlungsgutes als Alternative einsetzbar sein, wenn das Behandlungsgut von Transportmitteln durch ein Behandlungsbad hindurchgeführt wird.

Die weiteren Unteransprüche stellen bevorzugte Ausführungen der Erfindung dar.

Die erfindungsgemäßen Möglichkeiten an Verfahrensmaßnahmen, die zur Lösung der Aufgabe vorgesehen sind, können bevorzugt zum Galvanisieren, aber auch zum elektrolytischen Ätzen eingesetzt werden. Dabei hat das zu behandelnde Gut (Werkstück) anodische Funktion, d.h. ist anodisch angeschlossen. Das abgeätzte Metall wird auf einer Gegenelektrode (Kathode) niedergeschlagen. Die Gegenelektrode kann die Wischvorrichtung sein. Es wird dann in einem späteren Arbeitsgang davon abgetragen und wieder gewonnen. Ein solches elektrolytisches Ätzen ist eine Alternative zu einem rein chemischen Ätzen. Beim elektrolytischen Ätzen wird durch ein gleichzeitiges Wischen der Anoden eine dort auftretende Grenzschicht gestört werden.

Zur Vereinfachung der Darstellung der Erfindung wird diese nachfolgend und auch in der Beschreibung von Ausführungsbeispielen im Zusammenhang mit der Zeichnung an Hand von Verfahren und Vorrichtungen zum Galvanisieren erläutert.

Durch die Relativbewegung der mit einem Überzug versehenen Anode relativ zu dem zu galvanisierenden Behandlungsgut, wobei der Überzug am Behandlungsgut anliegt, wird die (siehe oben) Diffusionsschicht weitgehend zerstört und damit die an Metallionen verarmte Zone an der Oberfläche des Behandlungsgutes ganz oder zumindest überwiegend beseitigt. Die Ionen des Elektrolyten können durch den Überzug von der Anode direkt an die Oberfläche des Behandlungsgutes gelangen und dieses metallisieren. Es können hiermit relativ hohe Stromdichten erreicht werden, und zwar mit einer guten Qualität, insbesondere mit einer gleichmäßigen Stärke der auf der Warenoberfläche niedergeschlagenen Metallschicht, z.B. einer Kupferschicht. Dies ist ein wesentlicher Vorteil, der insbesondere dann von Bedeutung ist, wenn nicht die gesamte Fläche beschichtet werden soll, sondern nur die Oberfläche von Leiterbahnen, die sich auf einer solchen Leiterplatte befinden. Ein weiterer wesentlicher Vorteil der Erfindung besteht darin, daß der Abstand zwischen der Anode und der kathodischen Ware nur noch durch die Dicke des Überzuges der Wischvorrichtung bestimmt wid, wobei diese Dicke aber relativ gering sein kann. Aufgrund des somit erzielten, sehr geringen Abstandes zwischen Anode und Kathode sind unterschiedliche Feldlinienkonzentrationen des von der Anode zur Kathode fließenden Galvanisierstromes praktisch nicht vorhanden, zumindest wesentlich geringer als bei Anordnungen, bei denen zwischen Anode und Kathode ein demgegenüber größerer Abstand gegeben ist. Um die schädlichen Auswirkungen, nämlich erhöhte Metallniederschläge an Randbereichen, z.B. der sogenannte "Hundeknochen"-Effekt, bei vorbekannten Anordnungen mit einem relativ großen Abstand zwischen Anode und Kathode zu vermeiden, mußten entsprechende Aufwendungen, z.B. Abblendungen, vorgesehen werden. Dies gilt insbesondere für ein plattenförmiges Behandlungsgut, wie elektronische Leiterplatten, das mit einer Vielzahl von Bohrungen versehen ist. Hier können sich am Randbereich der Platten und in den Bohrlöchern Streuungen (sogenannte "Bohrlochstreuwerte") ergeben, die erheblich sind. Es ist ein wesentlicher Vorteil der Erfindung, daß mit ihr höhere Stromdichtewerte erreicht werden, ohne daß sich durch die Verarmung an Metallionen sogenannte Anbrennungen oder dergleichen des abzuscheidenden Metalls einstellen. Abblendungen oder ähnliche Maßnahmen gegen zu große Streuungen des Galvanisierstromes sind nicht nötig. Ein weiterer wesentlicher Vorteil der Erfindung liegt darin, daß sie zur automatischen Galvanisierung von eine Anlage kontinuierlich durchlaufendem Behandlungsgut (gelochte Platten oder dergleichen) geeignet ist. Dies wird bevorzugt bei horizontal angeordnetem und transportiertem Behandlungsgut erfolgen (siehe hierzu beispielsweise die später erläuterte DE-OS 36 24 481). Jedoch kann die Erfindung nicht nur bei horizontalem, sondern auch im vertikalen oder schrägen Durchlauf angewandt werden, und zwar bei Erzielung der vorstehend erläuterten Vorteile, insbesondere Vermeidung von schädlichen Streuungen bei hohen Stromdichten. Wenn höhere Stromdichten angewandt werden können, wie es das Ergebnis der Erfindung ist, wird auch die Transportgeschwindigkeit schneller oder die Behandlungsstrecke kürzer. Insbesondere ist es nicht nötig, für eine störend hohe Strömungsgeschwindigkeit des Elektrolyten zu sorgen.

Mit der Erfindung wird automatisch ein Wischeffekt an der gesamten zu behandelnden Oberfläche, insbesondere beider Seiten bzw. Flächen der plattenförmigen Ware erreicht. Der Vollständigkeit halber sei erwähnt, daß man zwar für die Galvanisierung von Hand das sogenannte Tampongalvanisieren kennt, wie es insbesondere zur Behandlung, Reparatur oder Ausbesserung von größeren Bauteilen angewendet wird, die nicht oder nur unter sehr erschwerten Umständen in einer Galvanisieranlage behandelt werden können. Typische Beispiele sind hierfür das Ausbessern oder Galvanisieren von metallischen Kirchendächern, von größeren Denkmälern und dergleichen mehr. Im einzelnen wird hierzu auf die Veröffentlichungen von RUBINSTEIN in der Zeitschrift "Galvanotechnik" Nr. 73 (1982) Seiten 120 ff, Nr. 79 (1988) Seiten 2876 ff und Seiten 3263 ff verwiesen. Ein solches Tamponverfahren ist aber nur für die vorgenannten Sonderfälle einsetzbar, nicht jedoch für die industrielle Fertigung von mit Bohrungen versehenen Platten oder dergleichen.

Bei einer bevorzugten Ausführungsform der Erfindung wird nicht nur die Transportgeschwindigkeit des Behandlungsgutes, sondern auch eine Eigengeschwindigkeit der anodischen, mit dem Überzug versehenen Vorrichtung zur Erzielung eines intensiven Wischeffektes eingesetzt. Es lassen sich je nach Anforderungen und Bauweise die unterschiedlichsten Effekte und Wischgeschwindigkeiten erreichen.

Die genannte Relativgeschwindigkeit kann gering sein, z.B. bis nahezu null. Ferner kann bei der Durchführung des erfindungsgemäßen Verfahrens ein Druck von der Wischvorrichtung auf das Behandlungsgut ausgeübt werden. Bei Vorhandensein eines elastischen Überzuges an der Wischvorrichtung kann der Überzug gestaucht oder gepreßt werden. Abgesehen davon, daß damit Ungleichheiten in der Dicke des Behandlungsgutes ausgeglichen werden können, trägt dies dazu bei, den erfindungsgemäßen Effekt der Störung der Diffusionsschicht zu verstärken. Insbesondere gilt dies für die offenbarten Kombinationen der Merkmale.

Weitere Verfahrensmaßnahmen fördern den Durchsatz des Elektrolyten durch die Bohrlöcher und damit die Metallisierung der Innenwände der Bohrlöcher. Sie tragen ferner dazu bei, in den Bohrlöchern vorhandene Partikel oder dergleichen aus diesen herauszubringen.

Der Erfindung liegt ferner die Aufgabe zugrunde, eine Anordnung zum elektrolytischen Behandeln von mit Bohrlöchern versehenen Leiterplatten, die von Transportmitteln durch ein Behandlungsbad hindurchbewegt oder zu einer Behandlungsstation geführt werden, wobei Mittel zur Reduzierung der Dicke einer an Metallionen verarmte Zone (Diffusionsschicht) vorgesehen sind, die sich im Kontakt mit den Leiterpiatten befinden, zu schaffen, welche eine einwandfreie und zugleich mit einfachen Mitteln mögliche elektrolytische Behandlung von einer oder beiden Oberflächen der Leiterplatten als auch der darin befindlichen Bohrungen oder Bohrlöcher (im folgenden kurz "Bohrlöcher" genannt) erreicht. Dies ist insbesondere mit den Verfahrensmaßnahmen nach einem oder mehreren der Verfahrensansprüche der vorliegenden Erfindung möglich.

Zur Lösung dieser Aufgaben- bzw. Problemstellung ist zunächst vorgesehen, daß die Anordnung Mittel zum Wischen der Oberfläche oder der Oberflächen entweder eines kathodischen Behandlungsgutes oder eines anodischen Behandlungsgutes und ferner Mittel zum Bewegen des Elektrolyten mit einer in etwa vertikal zur Ebene des Behandlungsgutes verlaufenden Strömung durch dessen Bohrlöcher hindurch aufweist (Flutungsmittel). Diese Lehre der Erfindung ist in konstruktiv einfacher Form zu verwirklichen, wie es aus den weiteren Ausführungen, insbesondere der Erläuterung der Ausführungsbeispiele noch näher hervorgeht.

Wischvorrichtungen mit dem Überzug sind eine für das maschinelle Wischen besonders günstige Ausführungsform der Erfindung.

Es empfiehlt sich, den Überzug mit einer gewissen Andruckkraft an der Oberfläche des Behandlungsgutes anliegen zu lassen. Dies ist insbesondere für die Behandlung der Leiterbahnen und Bohrlöcher von Vorteil, da die in den Bohrlöchern befindliche Flüssigkeit an ihren Oberflächen eine gewisse Oberflächenspannung hat, welche durch dieses Wischen gestört wird, so daß hiermit der Weg für Ionen zur Bildung einer Metallschicht (beim Galvanisieren) an den Oberflächen freigemacht wird. Eine solche Andruckkraft kann beispielsweise durch federnde Lagerungen der Wischvorrichtung, insbesondere der vorgenannten Roller erzielt werden.

Ein flaches Behandlungsgut ist besonders geeignet, zwischen Rollen hindurchgeführt zu werden. Rollen sind in ihrem Aufbau und Einsatz in Anlagen zur Behandlung von plattenförmigen Gegenständen an sich bekannt, jedoch nicht gemäß der Lehre der Erfindung in dieser Form der Wischrollen, sondern nur als Transport- und Führungsrollen sowie Abquetschrollen zum Abdichten. Sie haben den Vorzug eines einfachen und robusten Aufbaues und Einbaues in eine Behandlungsanlage. Im Unterschied zu bekannten Transportrollen oder Andruckrollen haben aber hier die Wischrollen mit ihren Überzügen die Funktion der Erzielung des erläuterten maschinell erzeugten Wischeffektes, d.h. ihre Umlaufgeschwindigkeit weicht bewußt von der Transportgeschwindigkeit des an ihnen anliegenden Behandlungsgutes ab. Sie können auch zugleich als Gegenelektrode zu dem zu behandelnden Gegenstand ausgebildet sein. Die vorgenannte Geschwindigkeitsabweichung kann durch die jeweiligen Größen der vorgenannten Geschwindigkeiten und/oder deren jeweiligen Richtungen erzielt werden. Auch an dieser Stelle ist zu sagen, daß die erwähnte Geschwindigkeitsabweichung bzw. Relativgeschwindigkeit gering, bis nahezu null sein kann. Ferner wird in dem Zusammenhang auf die Ausführungsmöglichkeit der Erfindung gemäß den Ansprüchen 23 und 43 sowie die Verfahrensmaßnahmen nach den Ansprüchen 10 und 11 verwiesen.

Die Wischrollen mit ihrem Überzug können ferner mechanisch den Abtrag von Partikeln begünstigen. Dies gilt insbesondere dann, wenn Sie mit einer gewissen Andruckkraft an die Oberfläche des Behandlungsgutes gedrückt werden. Auch können hierdurch Störschichten auf der Kathode, wie z.B. auf der Oberfläche hängende Gasbläschen entfernt werden.

Weitere bevorzugte Ausführungsformen zur Verstärkung der Metallisierung der Innenwand der Bohrlöcher bestehen in Mitteln und Vorrichtungen zum Hindurchbewegen (Fluten) des Elektrolyten durch die Bohrlöcher mit entsprechendem Überdruck oder Unterdruck. Hiermit wird auf die Flutungsmittel und zugehörige Anordnungen der Ansprüche 27 und folgende verwiesen. Insbesondere empfiehlt sich hierbei eine Anordnung nach den Ansprüchen 31 bis 34.

Weitere Vorteile und Merkmale der Erfindung sind den weiteren Unteransprüchen, sowie der nachfolgenden Beschreibung und der zugehörigen Zeichnung von erfindungsgemäßen Ausführungsmöglichkeiten zu entnehmen. In der im wesentlichen schematischen Zeichnung zeigt:
- Fig. 1:: eine prinzipielle Darstellung des Verfahrens nach der Erfindung, teilweise im Schnitt,
- Fig. 2:: in der Stirnansicht und zum Teil im Schnitt eine Ausführung zur Durchführung des oder der Verfahren nach der Erfindung.
- Fig. 3:: die zu Fig. 2 gehörende Seitenansicht,
- Fig. 4:: eine Draufsicht auf die Transportvorrichtung in Fig. 2 und Fig. 3,
Die nachfolgend angegebenen Figuren sind gegenüber den Darstellungen der Fig. 2 bis 4 durchweg in einem größeren Maßstab gezeichnet.
- Fig. 5:: die Transportvorrichtung im Schnitt gemäß der Linie V-V in Fig. 4,
- Fig. 6:: die in Fig. 2 umkreiste Einzelheit VI im vergrößerten Maßstab und zum Teil geschnitten
- Fig. 7:: ein erstes Ausführungsbeispiel in der Ausgestaltung und Anordnung der Wischrollen,
- Fig. 8:: ein zweites Ausführungsbeispiel in der Ausgestaltung und Anordnung der Wischrollen und des Flutens,
- Fig. 9:: ein drittes Ausführungsbeispiel hinsichtlich Ausgestaltung und Anordnung der Wischrollen, sowie der Zu- und Abführung der Elektrolytflüssigkeit und des Flutens,
- Fig. 10:: ein viertes Ausführungsbeispiel in der Ausführung und Ausgestaltung von Wischrollen, sowie der Zu- und Abführung der Elektrolytflüssigkeit und des Flutens,
- Fig. 11:: ein fünftes Ausführungsbeispiel in der Ausgestaltung und Anordnung von Wisch- und Tragrollen und der Zuführung der Elektrolytflüssigkeit, sowie des Flutens,
- Fig. 12, 13:: ein sechstes und siebentes Ausführungsbeispiel der Erfindung mit Wisch- und Flutungsmitteln,
- Fig. 14:: ein achtes Ausführungsbeispiel in der Ausgestaltung und Anordnung von Wisch- und Tragrollen und der Zuführung von Elektrolytflüssigkeit, sowie des Flutens,
- Fig. 15:: ein neuntes Ausführungsbeispiel der Erfindung in der Ausgestaltung der Wischrollen und einer zugehörigen Führung des Elektrolyten, sowie des Flutens,
- Fig. 16:: ein weiteres (zehntes) Ausführungsbeispiel der Erfindung zur Erzielung des Flut- und Wischeffektes,
- Fig. 17:: ein weiteres (elftes) Ausführungsbeispiel der Erfindung zur Erzielung des Flut- und Wischeffektes.

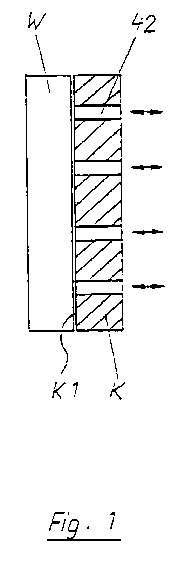

In der schematischen Darstellung der Fig. 1 ist das Prinzip der Erfindung dargestellt. Fig. 1 zeigt schematisch das Prinzip der Erfindung bei einem kathodischen Behandlungsgut K mit zu behandelnder Fläche K1 und dazugehöriger Wischvorrichtung W. Diese Wischvorrichtung W hat anodische Funktion. Die vorgenannte Wischvorrichtung kann Wischrollen gemäß den nachstehenden Ausführungsbeispielen aber auch andere Wischvorrichtungen sein. Der Wischvorgang erfolgt auf jeden Fall maschinell. Dies kann an einem durch eine Reihe von Behandlungsbädern hindurchgeführten Behandlungsgut, also im wesentlichen kontinuierlich, aber auch bei einem Behandlungsgut geschehen, das in eine der Behandlungsstationen bzw. in ein Behandlungsbad eingeführt und dort behandelt wird. Im letztgenannten Fall ist der Wischbetrieb und der nachstehend erläuterte Flutbetrieb diskontinuierlich. Bei einem plattenförmigen Behandlungsgut kann bzw. können sowohl eine der beiden Oberflächen, als auch beide Oberflächen des plattenförmigen Behandlungsgutes gewischt werden. Zugleich erfolgt ein Hindurchführen des Elektrolyten durch die Bohrlöcher (sogenanntes "Fluten"). Hinsichtlich Einzelheiten des vorgenannten Vorganges wird auf die nachstehend erläuterten Ausführungsbeispiele verwiesen.

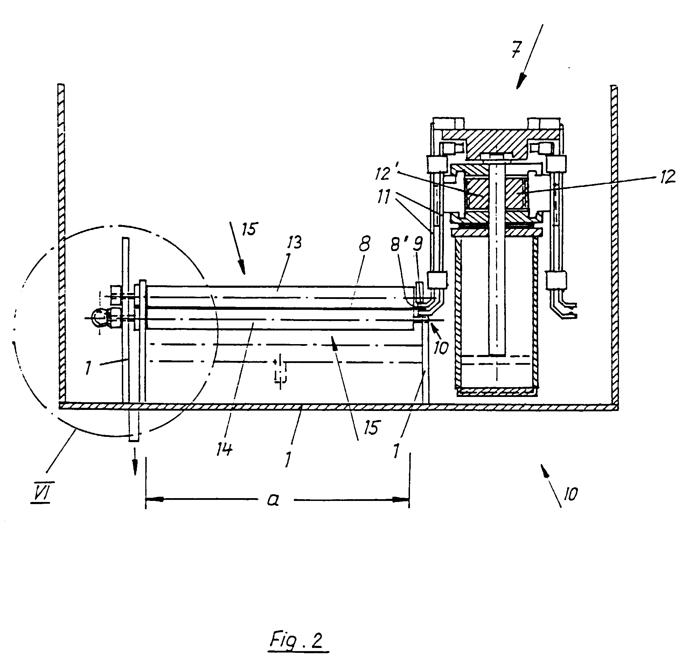

Die Fig. 2 bis 6 zeigen die eingangs bereits erwähnte, hauptsächliche Einsatzmöglichkeit der Erfindung, nämlich eine Badstation einer Galvanisieranlage, die gemäß der Erfindung ausgestaltet ist, einschließlich der Transportmittel für das Behandlungsgut. Es können eine Reihe solcher Badstationen hintereinander vorgesehen sein, um Behandlungen mit unterschiedlichen Bädern durchführen zu können.

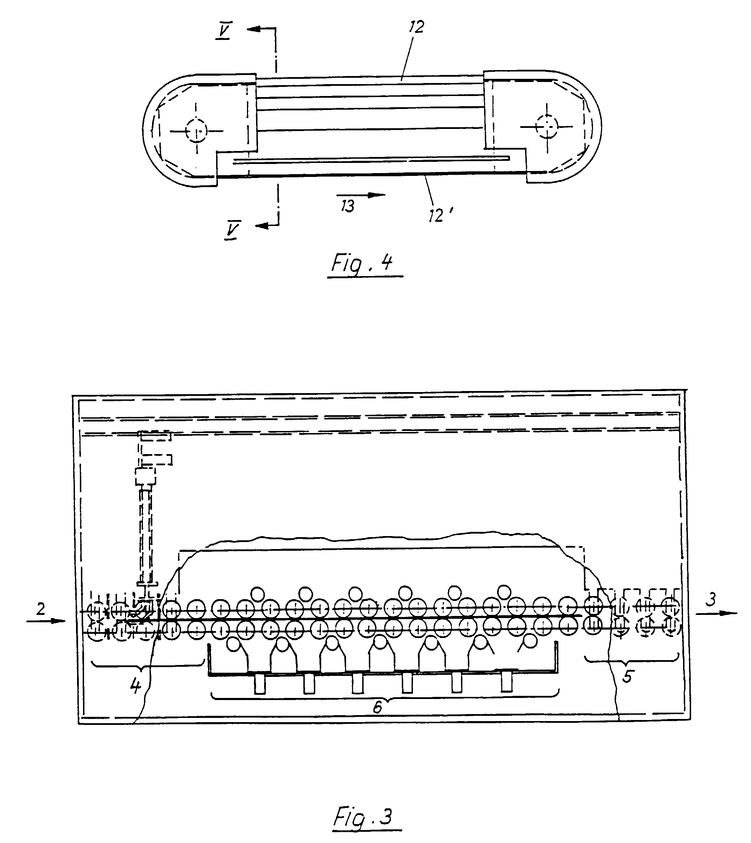

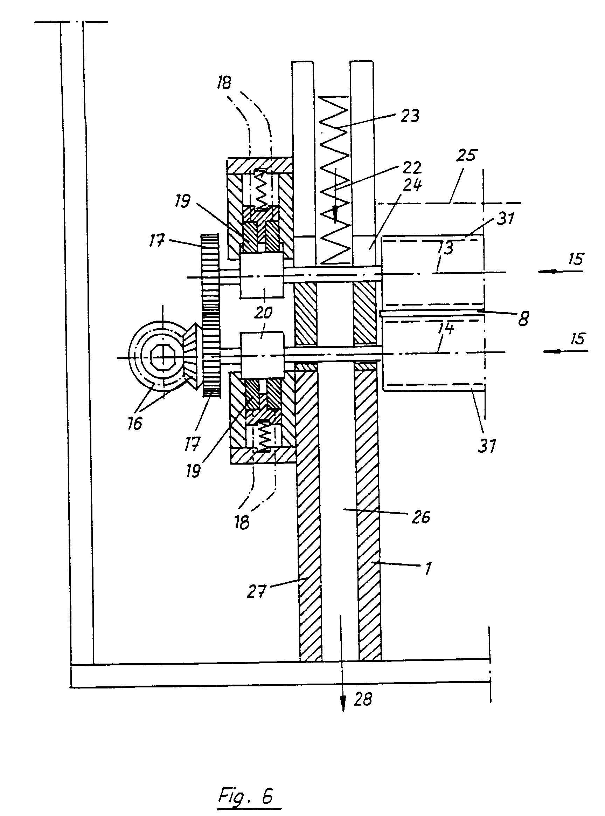

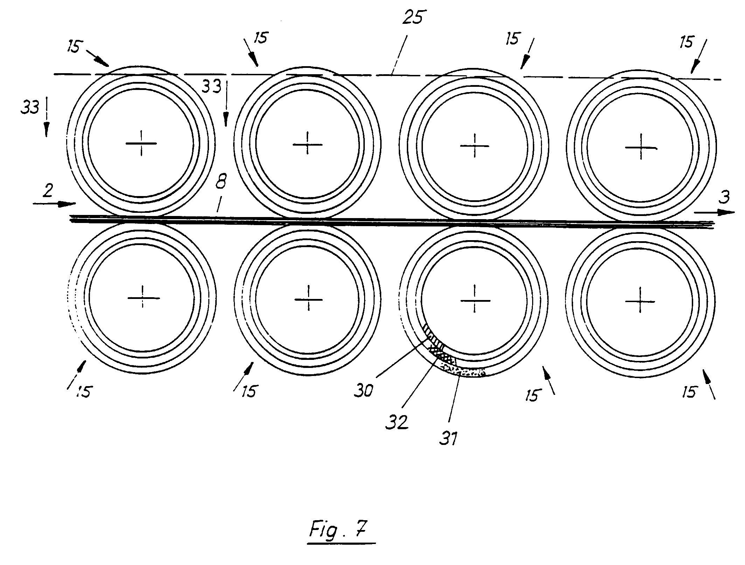

Im Badbehälter 1 befindet sich die nicht dargestellte Badflüssigkeit. Das in Pfeilrichtung 2 eingeführte Behandlungsgut wird zwischen Führungsrollen, Transportrollen und den noch näher zu erläuternden Wischrollen hindurchgeführt. Das Behandlungsgut kann gemäß diesem Ausführungsbeispiel der Erfindung horizontal transportiert und behandelt werden. Nach der Behandlung tritt das Gut in Pfeilrichtung 3 aus der Anlage wieder heraus. In den Bereichen 4 und 5 sind lediglich Transport- und/oder Führungsrollen vorhanden und dargestellt, während im Bereich 6 zusätzlich zu etwaigen Transport- und/oder Führungsrollen auch noch Wischrollen gemäß der Erfindung vorgesehen sind. Diese sind im einzelnen anhand mehrerer Ausführungsbeispiele der Fig. 6 bis 12 erläutert, wobei der Abschnitt 6 in Fig. 3 dem Ausführungsbeispiel der Fig. 7, 8 oder 9 entspricht.

Die Bewegungsbahn für das Behandlungsgut hat die in Fig. 2 mit "a" bezeichnete Position und Breite. Die Bewegungsrichtung 2-3 verläuft in Fig. 2 senkrecht zur Zeichenebene. Neben der Bewegungsbahn des Behandlungsgutes befindet sich in diesem Beispiel eine Transportvorrichtung 7, um ein in Fig. 2 mit Ziffer 8 angedeutetes plattenförmiges Behandlungsgut an einem seitlichen Rand 8' mit Transportmitteln in Form einer Klammer 9 klemmend zu erfassen und in der Transportrichtung 2-3 zu bewegen. Eine solche Transportvorrichtung ist Gegenstand von DE-OS 36 24 481, auf deren Offenbarungsinhalt hiermit Bezug genommen wird. Doch ist die Erfindung nicht auf die Verwendung einer derart gestalteten Transportvorrichtung beschränkt. Dieser seitliche Halt des plattenförmigen Behandlungsgutes durch die Klammern 9 hat besonders im Zusammenhang mit dem erläuterten "Fluten", d.h. dem Hindurchdrücken oder -saugen von Elektrolyt durch die Bohrlöcher des Gutes einen besonderen Vorteil. Bei diesem Fluten entsteht in der Flutungsrichtung ein entsprechender Druck auf das Behandlungsgut. Die seitlich am Behandlungsgut fest angreifenden Klammern verhindern, daß die jeweilige Platte durch den Flutdruck verschoben wird. Die vorgenannten Bohrlöcher und die Mittel zum Fluten sind allerdings aus Gründen der Übersichtlichkeit nicht in den Fig. 2 bis 6 dargestellt. Hierzu wird ebenfalls auf die nachfolgenden Ausführungsbeispiele verwiesen. Eine Klammer 9, bestehend aus zwei Bügeln 11, bildet ein Transportmittel 10. Sämtliche Transportmittel sind an einem endlos umlaufenden Förderband 12, 12' befestigt, das in Pfeilrichtung 13 (siehe Fig. 4) umläuft. Wenn sich die Transportmittel 10 auf der Seite des Trums 12' (siehe Fig. 3) des Förderbandes befinden, so sind die Klammern 9 in Halteposition (siehe die Darstellung der linken Seite der Transportvorrichtung 7 in Fig. 2). Sobald die Transportmittel 10 aus dem Bereich des Trums 12' heraus in den des in Fig. 4 oberen Trums 12 gelangen, werden die beiden Bügel 11 der Klammern 9 etwas auseinandergezogen, so daß zwischen ihnen ein Abstand besteht (siehe rechte Seite der Transportvorrichtung 7 in Fig. 2). Diese Transportvorrichtung bewegt das Behandlungsgut mit einer bestimmten, erforderlichenfalls einstellbaren Geschwindigkeit in der Richtung 2-3.

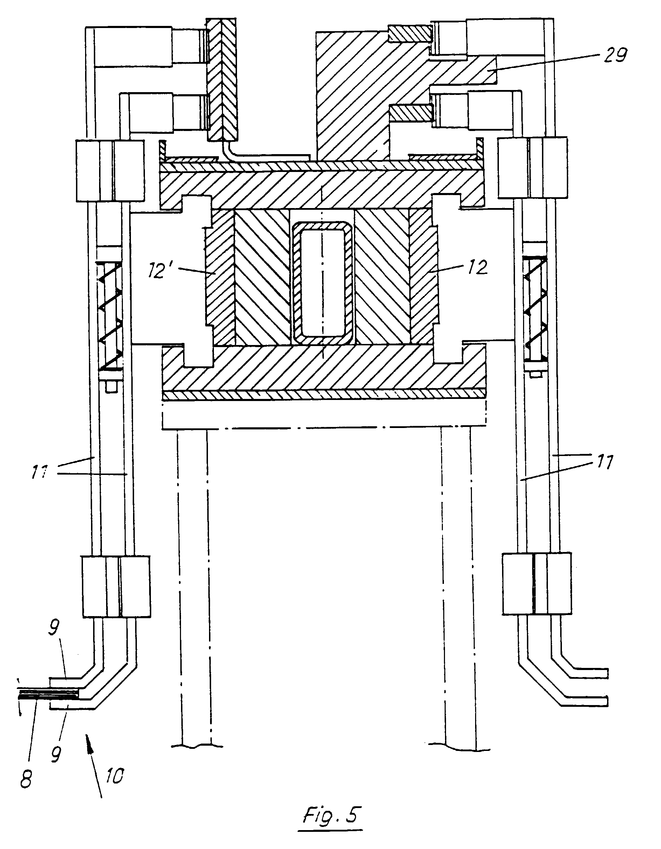

Fig. 5 zeigt die Transportvorrichtung im Detail. Daraus ist ersichtlich, daß im Bereich des Trums 12 durch Auflaufen eines der Bügel 11 einer Klammer auf ein Führungsteil 29 die zugehörigen Klammern 9 in die Offenstellung bewegt sind. Dagegen ist im Bahnbereich des Trums 12' ein solcher Führungsteil 29 nicht vorhanden und die Bügel der Klammern 9 liegen unter Wirkung einer Druckfeder mit entsprechender Klemmkraft am Rand 8' des Behandlungsgutes an (Transportstellung).

Die Einzelheit VI in Fig. 2 und die diese Einzelheit z. T. im Schnitt darstellende Fig. 6 zeigt zwei Wischrollen 15, die von einem Antrieb über ein Zahnradgetriebe 16, 17 gegenläufig bewegt werden. Hierzu dienen u.a. zwei Stirnräder 17, die auf den Achsen 13, 14 der Wischrollen 15 sitzen und miteinanaer kämmen. Die anodischen Wischrollen 15 sind über Kontaktscheiben 20 und daran gleitende Stromkontakte 19 sowie Zuleitungen 18 an den Pluspol der Stromquelle angeschlossen. Das hier nur teilweise dargestellte kathodische Behandlungsgut 8 ist mit dem Minuspol der Stromquelle verbunden (nicht dargestellt). Jede der Wischrollen ist an ihrem Außenumfang mit einem Überzug 31 aus einem den Elektrolyten und die Metallionen des Elektrolyten aufnehmenden und durchlassenden Material versehen. Dieses Material soll elastisch und von einer gewissen Weichheit sein, um beim Entlanggleiten an der Warenoberfläche-diese nicht zu beschädigen. Der Überzug muß gegen den Elektrolyten chemisch widerstandsfähig sein. Bevorzugt dient dafür ein filzartiger Kunststoff, z.B. aus Polypropylen. Dabei wird unter dem Begriff filzartig nicht der Textilstoff Filz, sondern eine Struktur ineinander verflochtener Bestandteile verstanden. Solche Materialien sind in der Praxis auch bei der Verwendung in Filtern bekannt. Der Überzug kann auch aus einem offenporigen Kunststoff bestehen, der gut flüssigkeitsdurchlässig und abriebfest ist. Dieser Wischbelag sollte - ebenso wie Wischbeläge aus anderen Materialien - elastisch sein, damit er sich beim Anliegen an der zu wischenden Oberfläche etwas zusammendrücken und danach wieder in die ursprüngliche Form zurückgehen kann. Die vorgenannte Flüssigkeitsdurchlässigkeit ist zumindest dann erforderlich, wenn gemäß einem der nachfolgenden Ausführungsbeispiele der Elektrolyt vom Rolleninnern durch den Überzug nach außen gedrückt, bzw. in umgekehrter Richtung gesaugt wird.

Während etwaige Antriebsrollen und/oder Führungsrollen (siehe Ziffer 4 und 5) eine Umfangsgeschwindigkeit haben, die in Größe und Richtung der Transportrichtung 2-3 und -geschwindigkeit der Transportmittel 10 entspricht, ist die Umfangsgeschwindigkeit und/oder Laufrichtung der Wischrollen derart, daß sich der Umfang der Wischrollen 15 relativ zur jeweiligen Oberfläche des transportierten Behandlungsgutes 8 bewegt. Somit wird über die gesamte Länge der Wischrollen 15 ein Wischeffekt auf die Oberflächen des Gutes 8 ausgeübt.

Die Länge der Wischrollen 15 erstreckt sich über die quer zur Transportrichtung verlaufenden Breite des Behandlungsgutes, d.h. etwa den Betrag a in Fig. 2. Es kann aber auch Behandlungsgut geringerer Breite bearbeitet werden, wobei dann lediglich eine Teillänge der Wischvorrichtung 15 ungenutzt ist. Der Badspiegel des elektrolytischen Bades ist gestrichelt mit Ziffer 25 angegeben, womit sich also das zu behandelnde Gut, sowie die Wischvorrichtungen unterhalb des Badspiegels in der Badflüssigkeit befinden. Dies kann auch für die übrigen Ausführungsbeispiele gelten. Wie das vorliegende Ausführungsbeispiel zeigt empfiehlt es sich, bzw. ist in der Regel notwendig, das Behandlungsgut an seinen beiden Seiten oder Flächen gemäß der Erfindung zu behandeln, d.h. an der in Fig. 2, 3 und 6 oberen Fläche und der unteren Fläche, wie es sich auch aus der Anordnung zweier Wischrollen 15 ergibt, die von oben bzw. von unten an den Flächen des Behandlungsgutes anliegen. In Fällen, in denen eine Behandlung nur einer der Flächen des Behandlungsgutes erforderlich ist, genügt dann vom Prinzip her der Einsatz einer Wischrolle. Daß auch mehr als zwei Wischrollen eingesetzt werden können, zeigen die Ausführungsbeispiele der Fig. 7 bis 15.

In der Regel empfiehlt sich eine gewisse Andruckkraft zwischen den Überzügen 31 der Wischrollen und den Oberflächen des Behandlungsgutes, die z. B. mittels einer in Fig. 6 schematisch angedeuteten und in Pfeilrichtung 22 drückenden Feder 23 aufgebracht werden kann. Um unterschiedlich dickes Behandlungsgut bearbeiten zu können ist hierzu die obere der Wischrollen 15 in einer Schlitzführung 24 gelagert und kann daher bei einer Vergrößerung der Dicke des Behandlungsgutes entgegen der Pfeilrichtung 22 ausweichen. Der Badspiegel 25 des Elektrolyten liegt höher als die Schlitzunterkante. Ein Überschuß an Elektrolyt kann daher durch die Schlitzführung 24 und einen Raum 26 zwischen der Seitenwand des Badbehälters 1 und einer weiteren, außen gelegenen Wand 27 gemäß Pfeilrichtung 28 auslaufen.

Die Umfangsgeschwindigkeit und/oder Drehrichtung der anodischen Wischrollen 15 an ihren Berührungsstellen mit dem eine bestimmte Transportgeschwindigkeit aufweisenden Gut kann durch Steuerung des Antriebes dieser Wischrollen entsprechend geändert und auf den gewünschten Wert eingestellt werden. Auch sind Einstellungen der Andruckkraft der Feder 23 oder eines anderen Andruckmittels möglich. Hiermit kann man sich den jeweiligen Anforderungen mit dem Ziel anpassen, eine möglichst weitgehende Störung der Diffusionsschicht an der Oberfläche der Ware, in der üblicherweise eine Ionenverarmung stattfindet, zu erreichen.

Bei der nachfolgenden Beschreibung von erfindungsgemäßen Ausführungsbeispielen in der Ausgestaltung und Anordnung von Wischrollen 15 oder entsprechend wirkenden Wischteilen sind nur diese Bauteile der Erfindung, einschließlich von Zu- und Ableitungen des Elektrolyten dargestellt und erläutert. Es versteht sich, daß hierzu Transportmittel des Behandlungsgutes und Antriebsmittel für die Wischteile, sowie Stromzuführungen gehören, die beispielsweise in den Fig. 2 bis 6 dargestellt und vorstehend erläutert sind. Zusätzlich zu den dort beschriebenen Transportmitteln, oder anstelle dieser Transportmittel ist es beispielsweise auch möglich, jeweils zwischen zwei Wischrollen Transportrollen vorzusehen, wobei die kathodische Stromzuführung mittels Schleifkontakten auf einen Randbereich des Behandlungsgutes erfolgt. Soweit nicht bereits in der Zeichnung dargestellt besitzt das zu behandelnde Gut Bohrlöcher und es sind Mittel vorgesehen, um diese Bohrlöcher zu "fluten", d.h. den Elektrolyt durch sie hindurchzuführen.

Grundsätzlich gilt, daß die im Elektrolysebad befindlichen Teile, wie das Rohr 30 und das nachstehend erläuterte Streckmetall oder Drahtgitter 32, aus einem Material bestehen müssen, das im Bad unter den Elektrolysebedingungen nicht angegriffen wird. Geeignet sind z.B. Titan, mit Platin beschichtetes Titan, Edelmetall, Edelmetallbeschichtung oder Edelmetalloxyde. Dies kann beispielsweise gemäß dem Ausführungsbeispiel der Fig. 7 derart geschehen, daß Wischrollen in Form von metallischen Rohren 30 mit dem vorstehend erläuterten filzartigen Überzug 31 und einem dazwischen befindlichen Streckmetall 32 vorgesehen sind, welche das Rohr 30 und den Überzug 31 formschlüssig miteinander verbindet. Anstelle des vorstehend erwähnten, bevorzugt rohrförmigen Streckmetalles kann auch ein bevorzugt rohrförmiges Drahtgitter, das an den Drahtkreuzungspunkten verschweißt ist, oder auch eine gelochte Röhre vorgesehen sein. In diesem Ausführungsbeispiel bildet das Rohr 30 eine unlösliche Anode, die selber kein Metall abgibt, sondern nur eine stromabgebende Funktion hat. Das abzuscheidende Metall befindet sich hier im Elektrolyten. Es ist aber auch möglich, das abzuscheidende Metall als lösliche Anode im Rohr 30 oder in einem anderen Wischelement zu deponieren. Beim Durchlaufen des Behandlungsgutes 8 werden die Überzüge 31 etwas zusammengedrückt. Der Elektrolyt wird gemäß Pfeilen 33 zugeführt. Auch dies kann unter Druck erfolgen. Er durchsetzt auch hier die nicht dargestellten Bohrlöcher der zu behandelnden Platte. Wie später am Schluß der Beschreibung erwähnt gilt auch hier, daß bei einem der Ausführungsbeispiele dargestellte Merkmale und Details auch bei anderen Ausführungsbeispielen verwendet werden können. Dies gilt insbesondere für die Mittel zur Durchführung des Flutens der Bohrlöcher 42 des zu behandelnden Gutes. Dieses und auch die übrigen Ausführungsbeispiele zeigt, daß der Abstand zwischen der Anode (hier das Titanrohr 31) und der Kathode (gleich der Ware 8) sehr gering ist, so daß praktisch keine Streuungen entstehen.

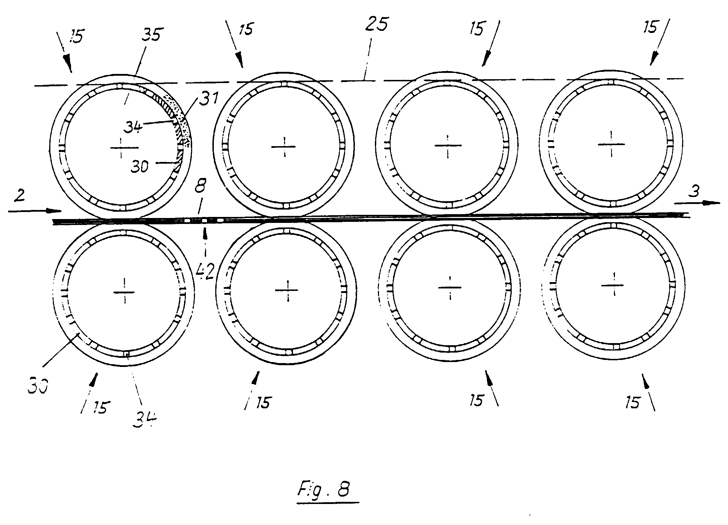

Das Ausführungsbeispiel der Fig. 8 ähnelt dem der Fig. 7. Fig. 8 zeigt aber eine der Ausführungsmöglichkeiten, um den Elektrolyt durch Bohrlöcher 42 des Behandlungsgutes hindurchströmen zu lassen. Hierzu sind die Rohre 30 mit Bohrungen 34 versehen, die mehrere Funktionen haben. Zum einen wird der Elektrolyt im Rohrinnern 35 zugeführt und durch die Bohrungen 34 an den Überzug 31 weitergegeben. Ferner wird der Elektrolyt vom Innern des Rohres 30 durch die Bohrungen 34 dieses Rohres und den Wischüberzug den Bohrlöchern 42 der Platte 8 zugeführt, strömt durch diese hindurch und gelangt in das Innere der jeweiligen Gegenrolle, deren Rohr 30 ebenfalls mit Bohrungen 34 versehen ist. Dabei kann der Elektrolyt in dem einen Rohr unter dem Druck einer Pumpe stehen und in der auf der anderen Seite des Behandlungsgutes befindlichen Gegenrolle aus den Bohrlöchern herausgesaugt werden. Außerdem können die Bohrungen 34 dazu dienen, daß sich das Material des Überzuges 31 in ihnen festkrallt. In dieser bevorzugten Ausführung sind nur das innere Rohr 30 und der äußere Überzug 31 vorgesehen. An die Stelle des mit den Bohrungen 34 versehenen Rohres 30 kann auch ein rohrförmiges Streckmetall oder Drahtgitter treten.

Es versteht sich, daß der Wischüberzug 31 die jeweilige Wischrolle 15 auf ihren gesamten Umfang umgibt. Dies gilt für sämtliche Ausführungsbeispiele, welche Wischrollen zeigen. Die Wischrollen sind allgemein mit 15 und einem zugehörigen Pfeil beziffert; ungeachtet ihrer jeweils etwas unterschiedlichen Ausgestaltung.

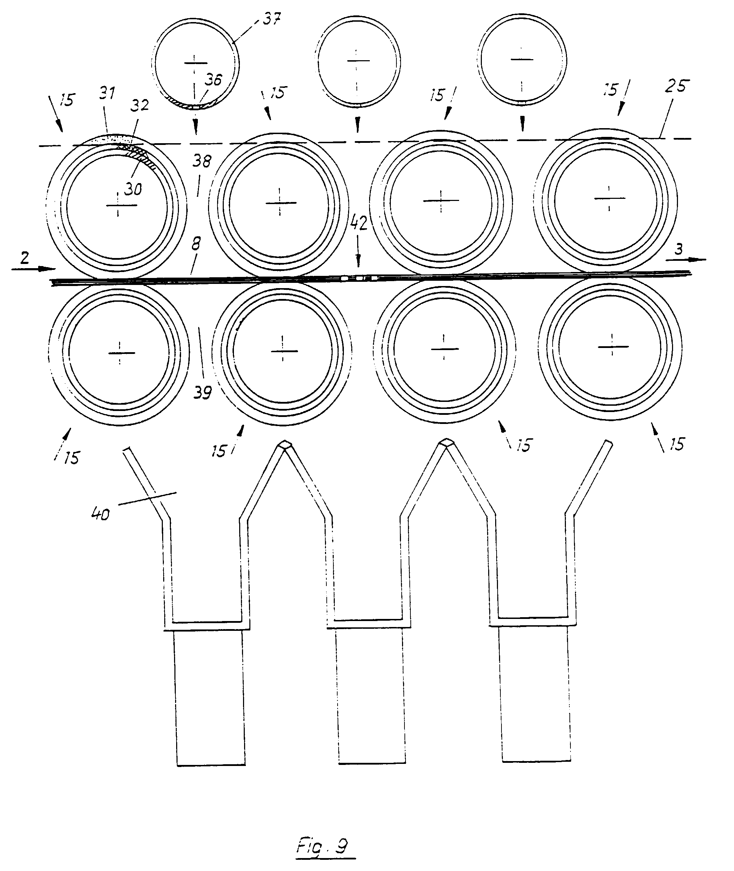

Im Ausführungsbeispiel der Fig. 9 bis 14 ist der Aufbau der Wischrollen ebenso wie im Beispiel der Fig. 7, nämlich aus einem inneren Rohr 30, einem Streckmetall oder dergleichen (siehe oben) 32 und dem die Wischrolle und damit auch das Rohr 30 umgebenden Überzug 31.

Die Zuführung des Elektrolyt erfolgt im Beispiel der Fig. 9 mittels mit Bohrungen oder Schlitzen 36 versehenen Zuführrohren 37, die sich oberhalb des freien Raumes 38 zwischen zwei Wischrollen 15 befinden. Nach Durchlaufen der Zwischenräume 38, der Bohrlöcher 42 und der darunter befindlichen Zwischenräume 39 wird der Elektrolyt von Auffangbehältern 40 aufgenommen und einer Filterpumpe zugeführt.

Wenn eine obere und eine untere Wischrolle einander gegenüberliegend vorgesehen sind (beispielsweise in der Ausführung gemäß Fig. 9), so könnte alternierend die obere Wischrolle anodisch und die darunter befindliche Wischrolle kathodisch geschalten werden und umgekehrt. Ein solches Verfahren und eine zugehörige Anordnung sind in der älteren Patentanmeldung P 41 06 333.3-45 der Anmelderin dargestellt und beschrieben. Auf deren Offenbarungsinhalt wird hiermit Bezug genommen.

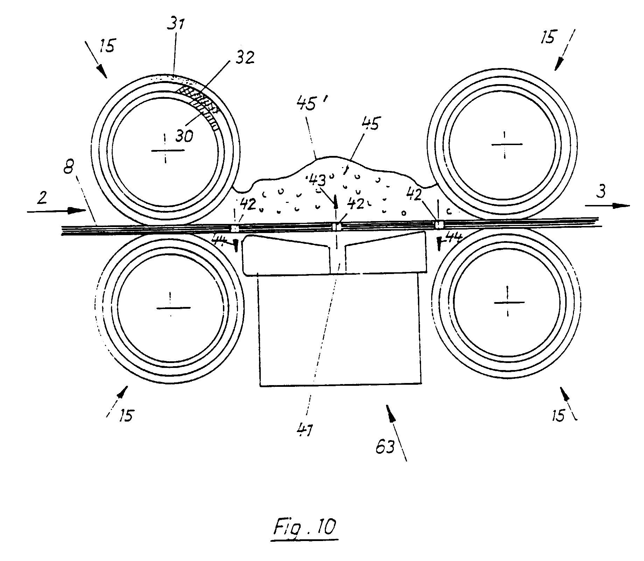

Das Ausführungsbeispiel der Fig. 10 zeigt Wischrollen 15 ebenfalls in der Ausführung gemäß Fig. 7 bei Behandlung von plattenförmigem Gut 8, insbesondere Leiterplatten, das mit Bohrlöchern 42 versehen ist. Der Elektrolyt wird mit Druck durch den Schlitz 41 einer Schwalldüse 63 nach oben (Pfeil 43) durch die darüber befindlichen Bohrlöcher 42 und von dort zurück mittels Unterdruck durch neben der Schwalldüse 63 befindlichen Bohrlöcher 42 (Pfeile 44) gefördert. Dabei wird oberhalb des Gutes 8 ein gewisser Stau 45 an Elektrolyt (mit Elektrolytoberfläche 45') aufgebaut, welcher die Überzüge der beiden oberhalb des Gutes 8 befindlichen Wischrollen mit Elektrolyt versorgt, während die unterhalb des Gutes befindlichen Wischrollen durch die Elektrolytströme 44, sowie durch den über den Rand der Schwalldüsen-Oberseite abfließenden Elektrolyten benetzt werden. Letzterer erreicht im engen Spalt zwischen dem Behandlungsgut und der Schwalldüse eine hohe Geschwindigkeit, wodurch dort ein niedrigerer Druck als in dem Elektrolyten oberhalb des plattenförmigen Behandlungsgutes entsteht. Dieser Differenzdruck bewirkt das Durchsaugen des Elektrolyten durch die Bohrlöcher 42. Eine solche Schwalldüsenanordnung kann alleine oder in Kombination mit anderen, der "Flutung" dienenden Mitteln (siehe hierzu die übrigen Ausführungsbeispiele) für das Hindurchbewegen des Elektrolyten durch die Bohrlöcher 42 vorgesehen werden.

Die zum Fluten nach der Erfindung möglichen Mittel können auch diffusionsarme Schichten in den Bohrungen 42 beseitigen, so daß an den Innenwandungen der Bohrungen 42 ein hinreichender Metallniederschlag stattfindet. Hinzu kommt, daß durch den Wischeffekt der Überzüge der Wischrollen an der Ober- und Unterseite des Gutes die Oberflächenspannung der in den Bohrungen 42 befindlichen Flüssigkeitssäulen stört und damit der angestrebte Effekt unterstützt wird. Wie eingangs bereits erwähnt, wirken also die Verfahrensmaßnahmen und Mittel zum Wischen der Oberflächen des plattenförmigen Gutes und zum Durchfluten der Bohrlöcher 42 des plattenförmigen Gutes funktionell und synergistisch zusammen.

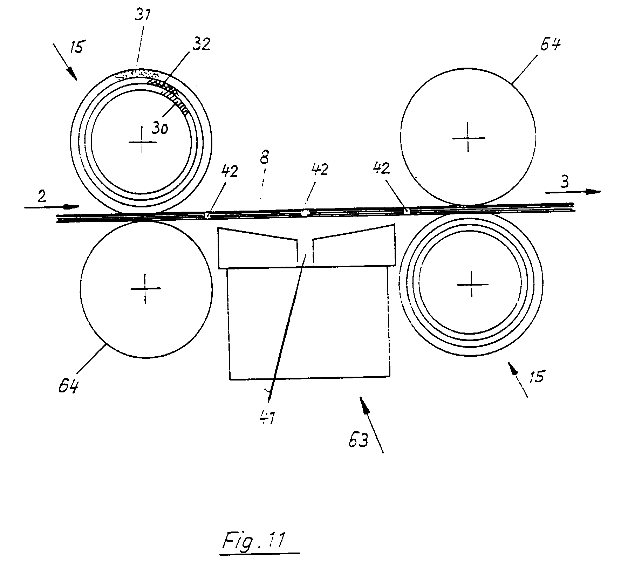

Das Ausführungsbeispiel der Fig. 11 ist eine Variante des Beispieles der Fig. 10. Hier ist im linken Rollenpaar eine obere Wischrolle 15 und eine untere Andruckrolle 64, sowie in dem rechts dargestellten Rollenpaar eine obere Andruckrolle 64 und eine untere Wischrolle 15 vorgesehen. Die Andruckrollen können die Funktion von Transportrollen oder von Stützrollen haben, die mit entsprechendem Druck am Behandlungsgut anliegen. Jede der anodischen Wischrollen 15 wischt im Sinne der Erfindung die ihr zugewandte Fläche des Behandlungsgutes 8 und gleichzeitig das ihr zugewandte Ende der Bohrungen 42. Ferner ist auch hier eine Schwalldüse 63 gemäß Fig. 10 vorgesehen. Es wird ein in der Transportrichtung 2-3 aufeinanderfolgendes Galvanisieren der Bohrungen 42 von alternierenden Seiten her erreicht. Die vorgenannten Transportrollen 64 sind zumindest auf der Oberseite des Behandlungsgutes als sich über die gesamte Breite des Behandlungsgutes bzw. der Behandlungsbahn erstreckende Walze ausgebildet, damit hierdurch der Elektrolyt auf dem Behandlungsgut 8 aufgestaut wird, während die Transportrollen an der Unterseite des Behandlungsgutes auch aus mehreren, auf einer Achse angeordneten Scheiben bestehen können, zwischen denen der Elektrolyt hindurchfließen kann.

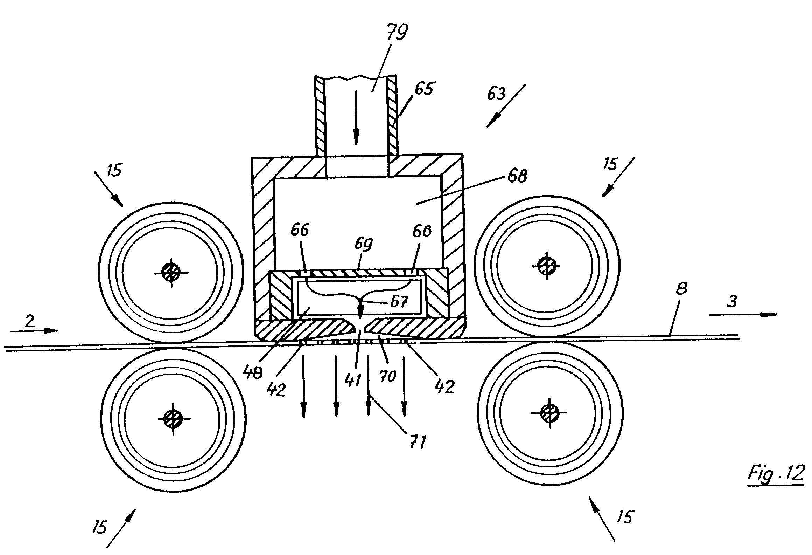

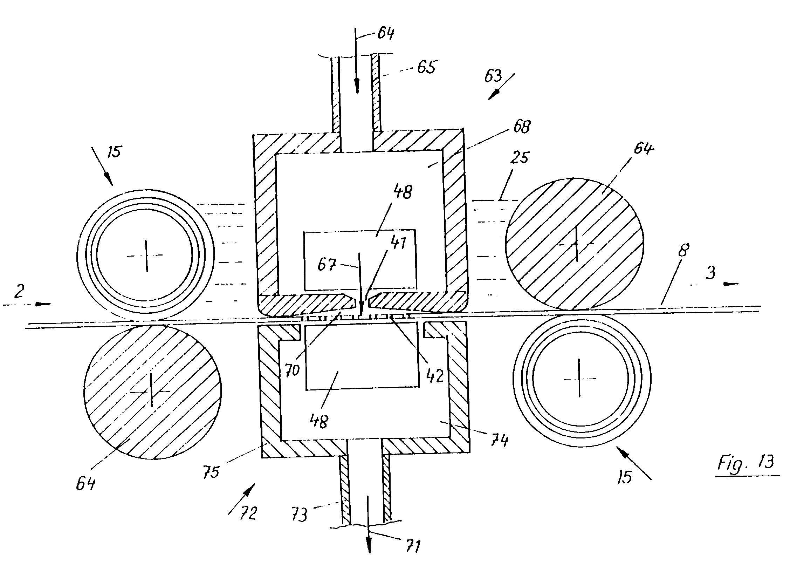

Die Figuren 12 und 13 zeigen weitere Möglichkeiten des Einsatzes einer Schwalldüse 63. Gemäß Fig. 12 sind zwei Paare Wischrollen 15 vor oder nach einer Anordnung vorgesehen, welche die Schwalldüse 63 mit darin angeordneter Anode 48 aufweist. Der Elektrolyt strömt in Richtung 79 durch einen Stutzen 65 ein, durchsetzt einen Vorraum 68 und eine Verteilermaske 69 mit Bohrungen 66, strömt (Ziffer 67) entlang der aus Einzelstücken bestehenden Anoden 48, durch den Schlitz 41 und den Schwallraum 70, sowie die Bohrungen 42 des Behandlungsgutes 8 hindurch nach unten (Pfeil 71) in den Bereich unterhalb des Behandlungsgutes 8. Im einzelnen wird hierzu Bezug genommen auf den Offenbarungsinhalt der DE-OS 39 16 693.7. Auch in diesen Ausführungsbeispielen handelt es sich beim mit Bohrungen versehenen Behandlungsgut bevorzugt um Leiterplatten.

Fig. 13 zeigt eine der Anordnung lt. Fig. 12 ähnliche Ausführung, wobei die gleichen Bezugsziffern verwendet sind. Der Unterschied liegt darin, daß beim Gegenstand von Fig. 12 der Elektrolyt nach Durchtritt durch die Bohrungen 42 nach unten frei abfließt, während beim Gegenstand von Fig. 13 zwischen diesem Abfluß 71 und dem Austritt des Elektrolyten aus den Bohrungen 42 noch eine Saugstrecke 72 mit Gehäuse 75 vorgesehen ist. Darin wird über den Saugstutzen 73 ein Unterdruck erzeugt, welcher den Elektrolyten nach Passieren einer weiteren Anode 48 in den unter dem Unterdruck stehenden Raum 74 und von dort durch den Stutzen 73 absaugt. Zum Gegenstand von Fig. 13 wird auf den Offenbarungsinhalt der DE-OS 39 16 694.5 Bezug genommen.

Bei den Ausführungsbeispielen der Fig. 10 bis 13 erstreckt sich die Schwalldüse 63 über die gesamte Breite des Behandlungsgutes, d.h. die Breite a im Ausführungsbeispiel der Fig. 2. Das gleiche gilt für den Raum 68 (Fig. 12, 13), in welchen die Elektrolyseflüssigkeit über eine in Querrrichtung des Behandlungsgutes hintereinander angeordneter Reihe von Stutzen 65 eintritt. Im Ausführungsbeispiel der Fig. 13 erstreckt sich die Saugstrecke 72 der Saugseite ebenfalls über die gesamte Breite a. Somit ist in diesen Ausführungsbeispielen mit Schwalldüse 63 dafür gesorgt, daß gemäß der Erfindung zusätzlich zu der Oberflächenbehandlung des Gutes 8 durch die Wischrolle 15 eine intensive Durchströmung der Gutbohrungen 42 durch den Elektrolyt erfolgt, und zwar über die gesamte Breite a der in Richtung 2-3 geförderten Werkstücke. Ein derartiges intensives Durchsetzen der Gutbohrungen 42 durch den Elektrolytstrom und damit ein entsprechend starker Niederschlag der Metallisierung an den Innenwänden dieser Bohrungen, und zwar dabei in Kombination mit der vorbeschriebenen Galvanisierung der Oberflächen des Behandlungsgutes aufgrund des Wischeffektes, wäre bei den Anordnungen nach dem Stand der Technik nicht möglich, bei denen der Elektrolytstrom mit großer Geschwindigkeit parallel und entlang der Werkstückoberfläche gefördert wird. Hierbei wäre es nämlich strömungstechnisch nicht verifizierbar, quer zu dieser Strömungsrichtung einen Elektrolytstrom durch die Bohrungen hindurch zu bringen.

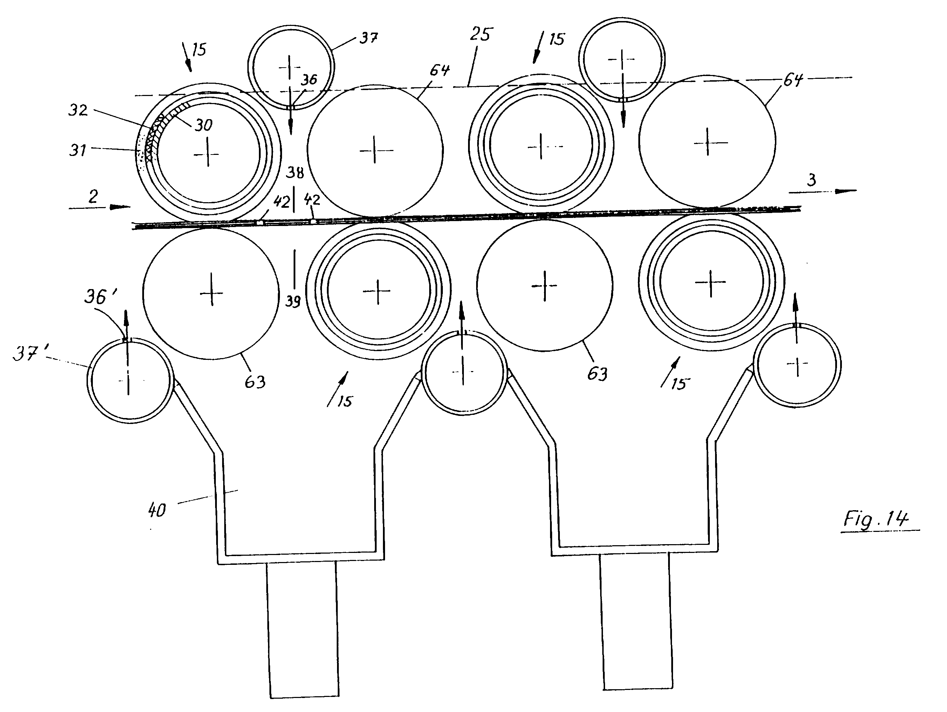

Das Ausführungsbeispiel der Fig. 14 beinhaltet eine Kombination der Anordnung von Wischrollen und Andruckrollen gemäß dem Ausführungsbeispiel der Fig. 11 mit einer Führung des Elektrolyten gemäß dem Ausführungsbeispiel der Fig. 9. Es sind dieselben Bezugsziffern wie in den Fig. 9, 11 verwendet. Zusätzlich sind noch untere Zuleitungen 37' mit Austrittsöffnungen 36' für den Elektrolyten vorgesehen, welchen den Elektrolyten von unten nach oben fördern.

Das Ausführungsbeispiel der Fig. 15 zeigt eine Abwandlung des Ausführungsbeispiels nach Fig. 14. Die Wischrollen 15 bestehen hier analog der anhand der Fig. 8 erläuterten Ausführung aus einem mit Bohrungen 34 versehenen inneren Rohr 30 oder einem rohrförmigen Streckmetall oder einem rohrförmigen Drahtgitter, bei denen die Drähte an ihren Kreuzungspunkten verschweißt sind, sowie aus dem erläuterten Überzug 31. Innerhalb des um seine Achse 76 umlaufenden Rohres 30 ist ein nicht rotierendes Zuführrohr 77 angeordnet, in das in einer hier nicht dargestellten Weise der Elektrolyt eingeführt wird, der durch Durchtrittsöffnungen, z.B. Bohrungen, oder Durchtrittsschlitze 78 der Wand des Rohres 77 wieder austritt, die in Längsrichtung des Rohres 77 hintereinander liegen. Es versteht sich, daß das Zuführrohr 77 mit den Durchtrittsöffnungen oder -schlitzen 78 sich über die gesamte Länge des Rohres 30 und damit die gesamte Breite a des zu behandelnden Gutes 8 erstreckt. Die Durchtrittsöffnungen oder -schlitze 78 sind mit ihren Ein- oder Ausgängen zur Bewegungsbahn 2-3 des Behandlungsgutes 8 gerichtet, so daß der durch die Durchtrittsöffnungen oder -schlitze 78 des Zuführrohres 77 durchfließende Elektrolyt durch die Bohrungen (oder entsprechende Schlitze) 34 des Rohres 30 hindurch senkrecht zum Behandlungsgut 8 auf dieses auftritt und dessen Bohrungen 42 durchsetzt. Es bewirkt also die Strömungsgeschwindigkeit des Elektrolyten durch die Bohrungen oder Schlitze 78 und die Bohrungen 34 hindurch eine entsprechende Vertikalströmung durch die Bohrungen 42 der Platte 8 und damit auch dort die Verbesserung des Metallniederschlages. Bei diesem Ausführungsbeispiel kann der Elektrolyt im Zuführrohr 77 entweder unter Druck stehen und entsprechend durch die Bohrungen oder Schlitze 78 und die Bohrlöcher 42 hindurchgedrückt werden. Oder es wird im Innern des Rohres 77 ein Unterdruck und damit ein Ansaugeffekt erzeugt, welcher den Elektrolyt durch die Bohrlöcher 42 und die Bohrungen oder Schlitze 78 hindurch saugt. Im letztgenannten Fall können etwa in die Bohrlöcher 42 geratene Partikel des Wischüberzuges herausgesaugt und über das Rohr 77 abgeführt und später aus dem abgeführten Elektrolyt herausgefiltert werden. Es versteht sich, daß im Ausführungsbeispiel der Fig. 15 ebenso wie bei den übrigen Ausführungsbeispielen eine Reihe von Löchern 34 kontinuierlich über den Umfang der Rolle 30 verteilt sind. Das vorgenannte Rohr 77 kann sich in einer Wischrolle sowohl oberhalb, als auch unterhalb des Behandlungsgutes befinden. Mit 64 sind auch hier Andruckrollen oder -scheiben bezeichnet, welche um die Achse 64' sich drehen und als Anlagerollen oder Transportrollen für das hindurchgeführte Gut 8 dienen.

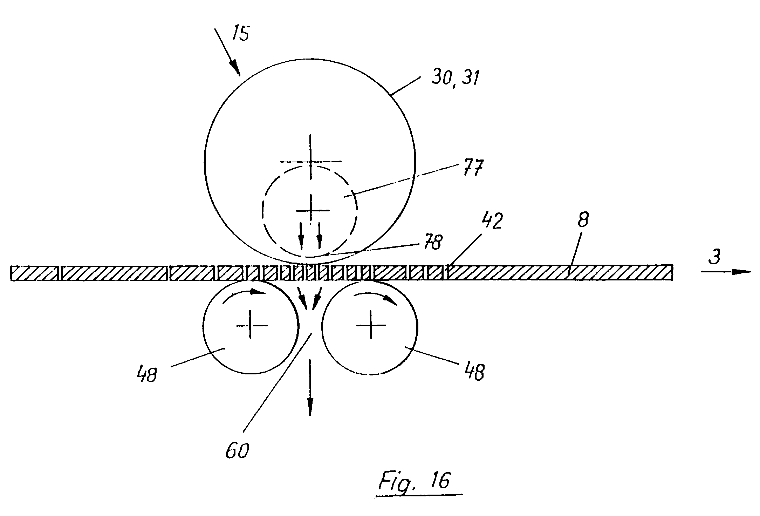

Fig. 16 zeigt schematisch oberhalb der mit Bohrlöchern 42 versehenen plattenförmigen Behandlungsgutes 8, z.B. eine Leiterplatte, eine Wischrolle 15 in Form einer Flutanode, welche den Teilen 30, 31, 77, 78 des Ausführungsbeispieles der Fig. 15 entspricht. Diese Teile sind hier nur schematisch angedeutet. Sofern im Zuführrohr 77 ein Druck des Elektrolyten gebildet wird, strömt er gemäß den eingezeichneten Pfeilen durch die Bohrlöcher 42 nach unten. Wird dagegen im Rohrinnern 77 ein Unterdruck erzeugt, so strömt der Elektrolyt entgegen der eingezeichneten Pfeilrichtung. Dieses Ausführungsbeispiel zeigt als Gegen- oder Andruckrolle zwei in Pfeilrichtung und damit auch in Transportrichtung 3 der Leiterplatte 8 angetriebene Gegenrollen 48, die unterhalb der Bohrungen oder Schlitze 78 des Zuführrohres 77 und damit in der Strömungsrichtung des Elektrolyten einen so breiten Raum 60 frei lassen, daß der Elektrolyt ungehindert zwischen den Gegenrollen 48 hindurchströmen kann. Trotzdem ist, aufgrund der Anordnung zweier symmetrisch zur Wischrolle 15 angeordneter Gegenrollen für eine gleichmäßige Verteilung des Druckes der Wischrolle 15 auf die Gegenrollen 48 gesorgt. Diese Gegenrollen sind an ihrer Oberfläche mit einer Isolierung versehen, oder sie bestehen aus Kunststoff.

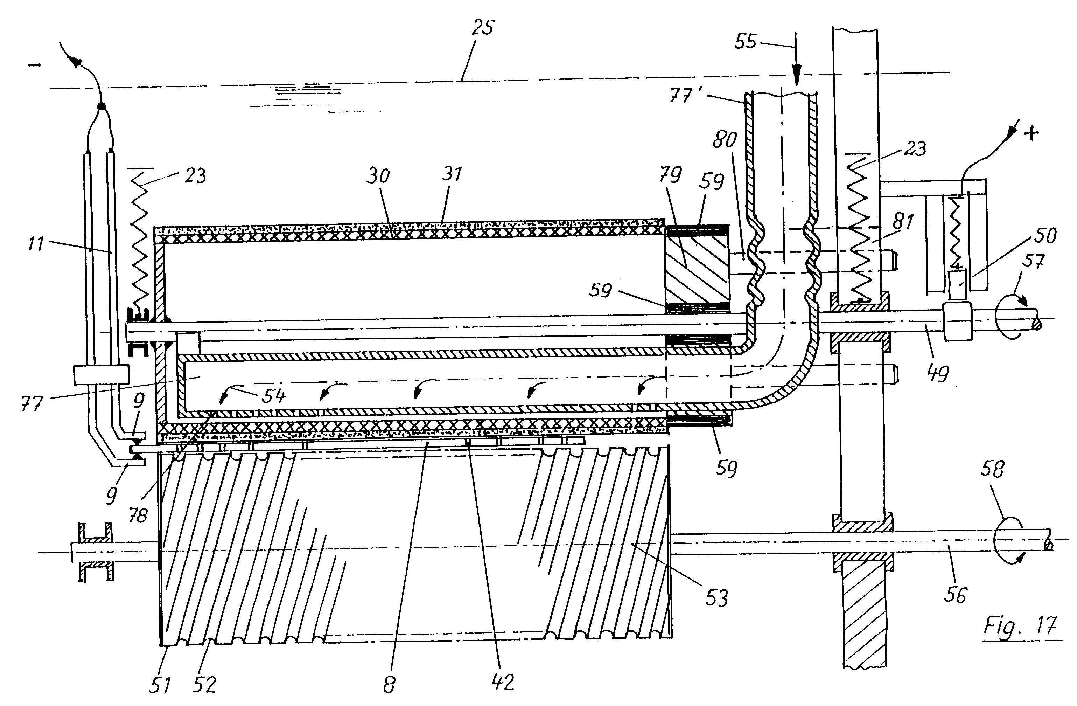

Fig. 17 zeigt in einem Längsschnitt das Ausführungsbeispiel einer Flutanode, wie sie in den Fig. 15, 16 nur schematisch dargestellt und mit den Ziffern 30, 31, 77, 78 deklariert ist. Es sind die gleichen Bezugsziffern verwendet wie in den Figuren 5, 6, 15 und 16. Auf die zugehörigen Beschreibungen dieser Figuren wird verwiesen. Die im oberen Bereich der Fig. 17 dargestellte Flutanode 30, 31, 77, 78 ist gegen den Druck der Federn 23 mit ihren Lagerungen und ihrer Antriebswelle 49 in Vertikalrichtung beweglich. Dies ermöglicht einen Höhenausgleich, um in ihrer Dicke unterschiedliche Platten 8 behandeln zu können. Die Stromzuführungen erfolgen über Klammern 9, 11, die an den einen Pol des Gleichrichters angeschlossen sind und diesen mit dem zu behandelnden Gut verbinden, sowie durch Schleifkontakte 50, die mit dem anderen Gleichrichterpol verbunden sind und diesen an die Antriebswelle 49 der Flutanode anschließen.

Ferner ist hier eine mindestens an der Oberfläche aus elektrisch nicht leitendem Werkstoff bestehende Andruck- oder Gegenrolle 51 vorgesehen, die an ihrem Umfang mit Drainagerinnen 52 versehen ist, wobei diese Rinnen mit der Längsachse 53 dieser Rolle 51 einen Winkel, hier einen spitzen Winkel, bilden. Hiermit wird der aus den Bohrlöchern 42 nach unten austretende Elektrolyt weggefördert. In diesem Fall wird, wie die eingezeichneten Pfeile zeigen, der Elektrolyt durch Druck in Pfeilrichtung 55 gefördert und gemäß den Pfeilen 54 durch die Bohrungen oder Schlitze 78 und anschließend durch die Bohrlöcher 42 hindurch gefördert und in die Drainagerinnen 52 geleitet. Statt dessen könnte auch am oberen Ende 77' des Flutrohres entgegen der Richtung des Pfeiles 55 gesaugt werden, womit der Elektrolyt von den Drainagerinnen 52 her durch die Löcher 78 und entgegen der Pfeilrichtung 54 nach oben gesaugt wird. Die Flutanode wird von ihrer Welle 49 in einer Drehrichtung (siehe Pfeil 57) angetrieben, die entgegengesetzt zur Drehrichtung gemäß Pfeil 58 der Antriebswelle 56 der Gegenrolle 51 gerichtet ist. Mit 50 ist ein Schleifkontakt der Stromzufuhr zur Antriebswelle 49 beziffert. Die Flutanode ist an ihrem einen Ende mit innen- und außenseitigen Gleitlagern 59 für das Rohr 30 und 59' für die Antriebswelle 49 versehen. Die vorgenannten Gleitlager 59, 59' befinden sich am Umfang bzw. am Innendurchmesser einer stationären Lagerschale 79, die über eine Strebe 80 am nicht näher bezeichneten Gestell dieser Anordnung gehalten ist und in einer Ausnehmung 81 um eine gewisse Wegstrecke vertikal beweglich geführt ist.

Bei Leiterplatten, bei denen die Bohrlochwandungen zunächst nur mit einer leitfähigen, keine größeren Stromdichten vertragenden, leitfähigen Schicht beschichtet sind, ist (siehe Fig. 3) im ersten Teil des Behandlungsabschnittes 6 zu Beginn zunächst mit geringeren Stromdichten zu arbeiten. Ist dort eine ausreichende Metallschicht abgeschieden worden, so kann dann im Verlauf des Transportes des Behandlungsgutes durch den Abschnitt 6 in Richtung 2-3 durch an sich bekannte Maßnahmen die Stromdichte des Galvanisiervorganges erhöht werden.

Des Verfahren und die Anordnungen nach der Erfindung sind auch für die Behandlung eines plattenförmigen Gutes geeignet, das senkrecht in Behandlungsbäder eingehängt wird und dort während der Behandlung verweilt. Es ist also nicht nur für den kontinuierlichen Durchlauf des Behandlungsgutes vorgesehen, sondern auch einen diskontinuierlichen Betrieb, indem das Gut in eine Station eingelegt wird und dort sich der Behandlung unterzieht. Während dieser Behandlung wird gewischt und geflutet. Es erfolgt also ein "periodisches" Wischen und Fluten während der Periode der betreffenden Badbehandlung.

## Patentansprüche

1. Verfahren zum elektrolytischen Behandeln von mit Bohrlöchern versehenen Leiterplatten, die von Transportmitteln durch ein Behandlungsbad hindurchbewegt oder zu einer Behandlungsstation geführt werden, wobei Mittel zur Reduzierung der Dicke einer an Metallionen verarmten Zone (Diffusionsschicht) vorgesehen sind, die sich im Kontakt mit den Leiterplatten befinden, bei Vorhandensein einer Anode und kathodischer Leiterplatten (K), oder Vorhandensein anodischer Leiterplatten und einer Kathode die zu behandelnden Flächen (K1) der Leiterplatten kontinuierlich und maschinell gewischt werden und der Elektrolyt mit einer zur Ebene der Leiterplatten im wesentlichen senkrechten Bewegungskomponente bewegt und durch deren Bohrlöcher (42) hindurchgeleitet wird.

2. Verfahren zum elektrolytischen Behandeln von mit Bohrlöchern versehenen Leiterplatten, die von Transportmitteln durch ein Behandlungsbad hindurchbewegt oder zu einer Behandlungsstation geführt werden, wobei Mittel zur Reduzierung der Dicke einer an Metallionen verarmten Zone (Diffusionsschicht) vorgesehen sind, die sich im Kontakt mit den Leiterplatten befinden, eine Relativbewegung zwischen kathodischen oder anodischen Leiterplatten (8) einerseits und einer anodenseitigen oder kathodenseitigen maschinellen Wischvorrichtung (15;46,47;53 ;59) andererseits erfolgt, welche zum Stören und zumindest teilweisen Zerstören der Diffusionsschicht direkt zur gleitenden Anlage auf die Oberflächen der Leiterplatten gebracht wird und der Elektrolyt mit einer zur Ebene der Leiterplatten im wesentlichen senkrechten Bewegungskomponente bewegt und durch deren Bohrlöcher (42) hindurchbewegt wird.

3. Verfahren nach Anspruch 2, dadurch gekennzeichnet, daß die vorgenannte Relativbewegung von einer Transportbewegung (2-3) der kathodischen oder anodischen Leiterplatten (8) zu der anodenseitigen oder kathodenseitigen Wischvorrichtung (15;16,47;53;59) geschaffen wird.

4. Verfahren nach Anspruch 2 oder 3, dadurch gekennzeichnet, daß die Bewegung der kathodischen Leiterplatten (8) relativ zu einer anodenseitigen Wischvorrichtung (15;46,47;53;59) erfolgt, welche einen Überzug (31;54;61) aus einem den Elektrolyt aufnehmenden und durchlassenden Material aufweist, und daß zum Stören, zumindest Reduzieren der Diffusionsschicht der Überzug direkt zur gleitenden Anlage auf die Oberflächen der Leiterplatten gebracht wird, während zur Reduzierung der Diffusionsschicht in den Bohrlöchern der Leiterplatten gleichzeitig der Elektrolyt mit einer zur Ebene der Leiterplatten im wesentlichen senkrechten Bewegungskomponente bewegt und durch deren Bohrlöcher (42) hindurchbewegt wird.

5. Verfahren nach einem der Ansprüche 1 bis 4, dadurch gekennzeichnet, daß entweder eine Oberfläche oder beide Oberflächen der Leiterplatten gewischt werden.

6. Verfahren nach einem der Ansprüche 2 bis 5, dadurch gekennzeichnet, daß die anodenseitige Wischvorrichtung (15;46,47;53;59) an ihrer Anlagestelle oder -fläche zur Oberfläche der Leiterplatten (8) eine Eigenbewegung besitzt, die von der Transportbewegung in Größe und/oder Richtung abweicht.

7. Verfahren nach einem der Ansprüche 1 bis 6, dadurch gekennzeichnet, daß im Falle einer beidseitigen Behandlung der Leiterplatten (8) deren Relativgeschwindigkeit zu der Wischvorrichtung auf ihrer einen Oberfläche entgegengesetzt zu deren Relativgeschwindigkeit zu der Wischvorrichtung an ihrer anderen Oberfläche gerichtet ist.

8. Verfahren nach einem der Ansprüche 2 bis 6, dadurch gekenzeichnet, daß im Falle einer beidseitigen Behandlung der Leiterplatten (8) deren Relativgeschwinfigkeit zu der der Wischvorrichtungen auf ihren beiden Oberflächen gleichgerichtet ist.

9. Verfahren nach einem der Ansprüche 2 bis 8, dadurch gekennzeichnet, daß die Relativgeschwindigkeit zwischen Leiterplatte und Wischvorrichtung gering ist, insbesondere bis nahezu null tendiert.

10. Verfahren nach einem der Ansprüche 1 bis 9, dadurch gekennzeichnet, daß ein Druck der Wischvorrichtung auf die Leiterplatten ausgeübt wird.

11. Verfahren nach einem der Ansprüche 4 bis 10, dadurch gekennzeichnet, daß bei Vorhandensein eines elastischen Überzuges der Wischvorrichtung der Überzug gestaucht oder gepreßt wird.

12. Verfahren nach einem der Ansprüche 1 bis 11, dadurch gekennzeichnet, daß im Verlauf der Bewegung (2-3) der Leiterplatten (8) durch die Behandlungsstrecke die Stromdichte des Galvanisierstromes erhöht wird.

13. Verfahren nach einem der Ansprüche 1 bis 12, dadurch gekennzeichnet, daß der Elektrolyt mit Druck durch die Bohrlöcher (42) hindurchgeführt wird.

14. Verfahren nach einem der Ansprüche 1 bis 13, dadurch gekennzeichnet, daß der Elektrolyt mittels Unterdruck aus den Bohrlöchern (42) herausgesaugt wird.

15. Verfahren nach einem der Ansprüche 1 bis 14, dadurch gekennzeichnet, daß das Wischen der Flächen und das Hindurchleiten des Elektrolyten durch die Bohrlöcher unterhalb des Badspiegels (25) und damit innerhalb der Badflüssigkeit erfolgt.

16. Anordnung zum elektrolytischen Behandeln von mit Bohrlöchern versehenen Leiterplatten, die von Transportmitteln durch ein Behandlungsbad hindurchbewegt oder zu einer Behandlungsstation geführt werden, wobei Mittel zur Reduzierung der Dicke einer am Metallionen verarmten Zone (Diffusionsschicht) vorgesehen sind, die sich im Kontakt mit dem Behandlungsgut befinden, insbesondere zur Durchführung des Verfahrens nach einem oder mehreren der Ansprüche 1 bis 15, und wobei Mittel (W) zum Wischen der Oberfläche oder der Oberflächen entweder kathodischer (K) oder anodischer Leiterplatten und ferner Mittel zum Bewegen des Elektrolyten in einer im wesentlichen vertikal zur Ebene der Leiterplatten (8) verlaufenden Strömung durch deren Bohrlöcher (42) vorgesehen sind.

17. Anordnung nach Anspruch 16, dadurch gekennzeichnet, daß für das Auftragen von Metall die Wischvorrichtung an der Anode vorgesehen ist.

18. Anordnung nach Anspruch 16 oder 17, dadurch gekennzeichnet, daß die anodenseitige oder kathodenseitige Wischvorrichtung (15;46,47;53;59) mit einem Überzug (31) versehen ist und an den Oberflächen der kathodischen oder anodischen Leiterplatten (8) zumindest während einer Relativbewegung zwischen Leiterplatte und Wischvorrichtung anliegt.

19. Anordnung nach Anspruch 18, dadurch gekennzeichnet, daß die Wischvorrichtung oder mehrere Wischvorrichtungen sich über die gesamte, etwa im rechten Winkel zur Transportrichtung verlaufende Breite oder den Umfang der transportierten Leiterplatten erstreckt oder erstrecken und zumindest die Leiterplatten relativ zu einer Wischvorrichtung bewegbar sind.

20. Anordnung nach einem der Ansprüche 16 bis 19, dadurch gekennzeichnet, daß der Überzug (31) mit einer einstellbaren Andruckkraft an den Oberflächen der Leiterplatten (8) anliegt.

21. Anordnung nach einem der Ansprüche 16 bis 20, dadurch gekennzeichnet, daß der Überzug (31) aus einem gegen den Elektrolyten chemisch widerstandsfähigen Material, insbesondere einem Kunststoff besteht.

22. Anordnung nach Anspruch 21, dadurch gekennzeichnet, daß der Überzug aus einem offenporigen Kunststoff besteht, der flüssigkeitsdurchlässig und abriebfest ist.

23. Anordnung nach Anspruch 21 oder 22, dadurch gekennzeichnet, daß der Überzug (31) aus einem elastischen Material besteht.

24. Anordnung nach einem der Ansprüche 16 bis 23, dadurch gekennzeichnet, daß die Wischvorrichtung aus zumindest einer Wischrolle (15) besteht, deren Umfang mit dem Überzug (31) versehen ist, daß ein Antrieb zum Drehen mindestens einer Wischrolle vorgesehen ist, deren Drehrichtung und/oder Umfangsgeschwindigkeit zur Erzeugung einer Relativgeschwindigkeit zwischen Anlagestelle oder Anlagefläche der Wischvorrichtung und den Oberflächen der Leiterplatten (8) wählbar ist.

25. Anordnung nach Anspruch 24, dadurch gekennzeichnet, daß die Wischrolle oder die Wischrollen (15) aus einem gelochten metallischen Rohr (30) oder Streckmetallrohr oder Drahtgitterrohr und einem zylindrischen, die Wischrolle umgebenden Überzug (31) besteht, wobei die Zu- oder Abfuhr des Elektrolyten innerhalb des Rohres, Streckmetalles oder Drahtgitterrohres erfolgt.

26. Anordnung nach Anspruch 24, dadurch gekennzeichnet, daß die Wischrolle oder die Wischrollen aus einem metallischen Rohr und einem zylindrischen, die Wischrolle umgebenden Überzug (31) bestehen, wobei Überzug und Rohr durch ein dazwischen befindliches Streckmetall (32) oder ein Drahtgitter aneinander gehalten sind, und daß die Elektrolytzuführung von einer Stelle (33) außerhalb der Wischrolle oder Wischrollen zu den Bohrungen (42) der Leiterplatten (8) erfolgt.

27. Anordnung nach einem der Ansprüche 24 bis 26, dadurch gekennzeichnet, daß einer an einer Oberfläche der Leiterplatten anliegenden Wischrolle (15) mit Flutungsmitteln eine an der anderen Oberfläche anliegende Andruckrolle (64) gegenüberliegt.

28. Anordnung nach Anspruch 27, dadurch gekennzeichnet, daß im Fall beidseitiger Galvanisierung der Leiterplatten in der Behandlungsrichtung (3) hintereinander Paare einander gegenüberliegender Rollen angeordnet sind, wobei abwechselnd bei einem Paar eine Wischrolle (15) mit Flutungsmitteln oberhalb und eine Andruckrolle (64) unterhalb der Leiterplatten (8) sowie beim nächsten Paar eine Wischrolle mit Flutungsmitteln unterhalb und eine Andruckrolle oberhalb der Leiterplatten vorgesehen ist.

29. Anordnung nach einem der Ansprüche 24 bis 26, dadurch gekennzeichnet, daß zumindest ein Paar Wischrollen einander gegenüberliegend vorgesehen sind, wobei sich eine der Rollen oberhalb und die andere Rolle unterhalb der Leiterplatten (8) befindet und die Flußrichtung des Elektrolyten in beiden Wischrollen dieselbe ist.

30. Anordnung nach einem der Ansprüche 24 bis 29, dadurch gekennzeichnet, daß eine Führung des Elektrolyten im Inneren des Rohres (30) einer Wischrolle und ein Durchtritt des Elektrolyten zwischen dem Rohrinnern, dessen Wandung und dem das Rohr umgebenden Überzug (31) besteht.

31. Anordnung nach Anspruch 30, dadurch gekennzeichnet, daß eine Reihe von Durchtrittsöffnungen (34) in der Rohrwandung vorgesehen ist.

32. Anordnung nach einem der Ansprüche 24 bis 31, dadurch gekennzeichnet, daß innerhalb des mit Durchtrittsöffnungen (34) für den Elektrolyten versehenen rotierenden Rohres (30) ein den Elektrolyten führendes Zuführrohr (77) mit Durchtrittsöffnungen oder -schlitzen (78) vorgesehen ist, wobei die Durchtrittsöffnungen oder -schlitze (78) mit ihren Durchtritts-Endflächen zur Bewegungsbahn (2-3) der Leiterplatten (8) gerichtet sind und daß sich das Zuführrohr (77) ebenso wie das rotierende Rohr (30) über die gesamte Breite (a) der Bahn der Leiterplatten erstreckt.

33. Anordnung nach Anspruch 32, dadurch gekennzeichnet, daß die Durchtrittsöffnungen oder -schlitze (78) des Zuführrohres (77) sich möglichst nahe bei den Leiterplatten (8) befinden.

34. Anordnung nach Anspruch 32 oder 33, dadurch gekennzeichnet, daß das Zuführrohr (77) im Rohr (30) nicht rotierend angebracht ist.

35. Anordnung nach einem der Ansprüche 32 bis 34, dadurch gekennzeichnet, daß das rotierende Rohr (30) zusammen mit dem darin befindlichen Zuführrohr (77) im wesentlichen vertikal zur Ebene der Leiterplatten (3) beweglich gelagert ist.

36. Anordnung nach einem der Ansprüche 24 bis 35, dadurch gekennzeichnet, daß für die Zuführung des Elektrolyten in die Räume (38,39) zwischen zwei Wischrollen (15) ein oder mehrere Rohre (37) mit Öffnungen (36) für den Elektrolyten angeordnet ist oder sind, und daß unterhalb der Räume (38,39) Auffangvorrichtungen (40) für den Elektrolyten vorgesehen sind.

37. Anordnung nach einem der Ansprüche 16 bis 36, dadurch gekennzeichnet, daß druckerzeugende Mittel für die Zufuhr des Elektrolyten zu den Bohrlöchern (42) der Leiterplatten vorgesehen sind.

38. Anordnung nach einem der Ansprüche 16 bis 37, dadurch gekennzeichnet, daß Mittel zum Saugen des Elektrolyten aus dem Bohrlöchern (42) der Leiterplatten vorgesehen sind.

39. Anordnung nach Anspruch 37 oder 38, dadurch gekennzeichnet, daß zum Galvanisieren von mit Bohrlöchern (42) versehenen Leiterplatten (8) eine Schwalldüse (63) vorgesehen ist, welche den Elektrolyt durch im Bereich der Schwalldüsenöffnung oder -schlitze (41) liegende Bohrlöcher (42) hindurchdrückt, während im Randbereich der Schwalldüse der Rücklauf des Elektrolyten durch andere Bohrlöcher (42) mit Hilfe eines auf der Unterseite der Leiterplatten vorhandenen Unterdruckes erfolgt, wobei sich die Schwalldüse über die gesamte Breite der zu behandelnden Leiterplatten (8) erstreckt.

40. Anordnung nach Anspruch 39, dadurch gekennzeichnet, daß innerhalb der Schwalldüse (63) sich Anoden (48) befinden, und zwar bevorzugt innerhalb eines von einem Gehäuse umgebenen Vorraumes (68), dem der Elektrolyt zugeführt (65) wird.

41. Anordnung nach Anspruch 39 oder 40, dadurch gekennzeichnet, daß auf der Austrittsseite der Bohrlöcher (42), denen durch die Schwalldüse (63) der Elektrolyt mit Druck zugeführt wird, sich eine Ansaugvorrichtung (72) befindet, deren unter Unterdruck stehendes Gehäuse (75) sich über die gesamte Breite (a) der zu behandelnden Leiterplatten erstreckt.

42. Anordnung nach einem der Ansprüche 16 bis 35, 37 bis 41, dadurch gekennzeichnet, daß den Elektrolyten von unten nach oben fördernde untere Rohre (37') mit Durchtrittsöffnungen (36') vorgesehen sind.

43. Anordnung nach einem der Ansprüche 16 bis 42, dadurch gekennzeichnet, daß die Wischvorrichtung oder die Wischvorrichtungen unter Federkraft (23,55) an den jeweiligen Oberflächen der Leiterplatten anliegen.

44. Anordnung nach einem der Ansprüche 16 bis 43, dadurch gekennzeichnet, daß die zu behandelnden Leiterplatten (8) in horizontaler Lage in der Behandlungsstation gelegen und geführt sind.

45. Anordnung nach Anspruch 44, dadurch gekennzeichnet, daß für den Transport der Leiterplatten in horizontaler Lage an mindestens einer seiner Seitenränder (8') anfassende Transportmittel (10), bevorzugt Klammern (9) vorgesehen sind.

46. Anordnung nach einem der Ansprüche 16 bis 45, dadurch gekennzeichnet, daß die einer Wischrolle (15) in Form einer Flutungsrolle (30,31,77,78) gegenüberliegenden Andruckrollen (51) mit Drainagerinnen (52) versehen sind, welche der Ableitung des Elektrolyten dienen.

47. Anordnung nach einem der Ansprüche 16 bis 45, dadurch gekennzeichnet, daß der Wisch- und Flutungsrolle (15;31,77,78) auf der anderen Seite der Leiterplatten gegenüberliegend zwei Gegenrollen (48) gelagert und so positioniert sind, daß sie zwischen sich einen Durchflußraum (60) für den Elektrolyten bilden, der entweder durch Druck aus der Flutungsrolle in die Bohrlöcher (42) der Leiterplatten gedrückt oder durch Ansaugen in die Flutungsrolle durch die Bohrlöcher (42) hindurch angesaugt wird.

48. Anordnung nach einem der Ansprüche 16 bis 47, dadurch gekennzeichnet, daß die Dicke des Überzuges (31) relativ gering ist, vorzugsweise 1-4 mm beträgt.

49. Anordnung nach einem der Ansprüche 16 bis 48, dadurch gekennzeichnet, daß unterschiedliche Wischvorrichtungen miteinander kombiniert für die elektrolytische Behandlung der gleichen Leiterplatten vorgesehen sind.

## Claims

1. Method of electrolytically treating printed circuit boards, which are provided with bores and moved through a treatment bath by conveyor means or guided to a treatment station, means for reducing the thickness of a zone (diffusion layer), which is deprived of metal ions, being provided and in contact with the printed circuit boards, the areas (K1) of the printed circuit boards to be treated being continuously and mechanically wiped in the presence of an anode and cathodic printed circuit boards (K), or in the presence of anodic printed circuit boards and a cathode, and the electrolyte is moved with a movement component, which is substantially perpendicular to the plane of the printed circuit boards, and is conducted through the bores (42) in said boards.

2. Method of electrolytically treating printed circuit boards, which are provided with bores and moved through a treatment bath by conveyor means or guided to a treatment station, means for reducing the thickness of a zone (diffusion layer), which is deprived of metal ions, being provided and in contact with the printed circuit boards, a relative movement being effected between cathodic or anodic printed circuit boards (8), on the one hand, and a mechanical wiping device (15;46,47;53;59) at the anode end or cathode end, on the other hand, said wiping device being brought directly into sliding abutment on the surfaces of the printed circuit boards in order to disturb and at least partially destroy the diffusion layer, and the electrolyte is moved with a movement component, which is substantially perpendicular to the plane of the printed circuit boards, and is moved through the bores (42) in said boards.

3. Method according to claim 2, characterised in that the above-mentioned relative movement is created by a conveyor movement (2-3) of the cathodic or anodic printed circuit boards (8) relative to the wiping device (15;46,47;53;59) at the anode end or cathode end.

4. Method according to claim 2 or 3, characterised in that the movement of the cathodic printed circuit boards (8) is effected relative to a wiping device (15;46,47;53;59) at the anode end, which device has a coating (31;54;61) formed from a material which absorbs the electrolyte and permits it to pass therethrough, and in that the coating is brought directly into sliding abutment on the surfaces of the printed circuit boards in order to disturb, or at least reduce the diffusion layer, while the electrolyte is simultaneously moved with a movement component substantially perpendicular to the plane of the printed circuit boards to reduce the diffusion layer in the bores in the printed circuit boards and is moved through the bores (42) in said boards.

5. Method according to one of claims 1 to 4, characterised in that either one surface is wiped, or both surfaces of the printed circuit boards are wiped.

6. Method according to one of claims 2 to 5, characterised in that the wiping device (15;46,47;53;59) at the anode end has an inherent movement at its abutment location or area relative to the surface of the printed circuit boards (8), which movement differs in size and/or direction from the conveyor movement.

7. Method according to one of claims 1 to 6, characterised in that, in the case of a two-sided treatment of the printed circuit boards (8), their relative speed relative to the wiping device on their one surface is directed to the wiping device on their other surface in opposition to their relative speed.

8. Method according to one of claims 2 to 6, characterised in that, in the case of a two-sided treatment of the printed circuit boards (8), their relative speed relative to that of the wiping devices on their two surfaces is orientated in the same direction.

9. Method according to one of claims 2 to 8, characterised in that the relative speed between printed circuit board and wiping device is minimal, and more especially tends to virtually zero.

10. Method according to one of claims 1 to 9, characterised in that a pressure of the wiping device is exerted upon the printed circuit boards.

11. Method according to one of claims 4 to 10, characterised in that, with the presence of a resilient coating of the wiping device, the coating is compressed or pressed.

12. Method according to one of claims 1 to 11, characterised in that, during the course of the movement (2-3) of the printed circuit boards (8) through the treatment path, the current density of the galvanising current is increased.

13. Method according to one of claims 1 to 12, characterised in that the electrolyte is guided through the bores (42) with pressure.

14. Method according to one of claims 1 to 13, characterised in that the electrolyte is sucked from the bores (42) by means of reduced pressure.

15. Method according to one of claims 1 to 14, characterised in that the wiping of the areas and the guidance of the electrolyte through the bores are effected beneath the level of the bath (25) and, in consequence, internally of the bath fluid.

16. Arrangement for electrolytically treating printed circuit boards, which are provided with bores and moved through a treatment bath by conveyor means or guided to a treatment station, means for reducing the thickness of a zone (diffusion layer), which is deprived of metal ions, being provided and in contact with the material being treated, more especially for accomplishing the method according to one or more of claims 1 to 15, and wherein means (W) for wiping the surface or the surfaces of either cathodic (K) or anodic printed circuit boards are provided, and means are also provided for moving the electrolyte in a flow through the bores (42) in the printed circuit boards (8), which flow extends substantially vertically relative to the plane of said boards.

17. Arrangement according to claim 16, characterised in that the wiping device is provided on the anode for the coating of metal.

18. Arrangement according to claim 16 or 17, characterised in that the wiping device (15;46,47;53;59) at the anode end or cathode end is provided with a coating (31) and abuts against the surfaces of the cathodic or anodic printed circuit boards (8), at least during a relative movement between printed circuit board and wiping device.

19. Arrangement according to claim 18, characterised in that the wiping device or a plurality of wiping devices extends or extend over the entire width, which extends substantially at right angles to the direction of conveyance, or over the periphery of the conveyed printed circuit boards, and at least the printed circuit boards are displaceable relative to a wiping device.

20. Arrangement according to one of claims 16 to 19, characterised in that the coating (31) abuts against the surfaces of the printed circuit boards (8) with an adjustable compression force.

21. Arrangement according to one of claims 16 to 20, characterised in that the coating (31) is formed from a material, which is chemically resistant to the electrolyte, more especially a plastics material.

22. Arrangement according to claim 21, characterised in that the coating is formed from an open-pored plastics material, which is permeable to fluids and wear-resistant.

23. Arrangement according to claim 21 or 22, characterised in that the coating (31) is formed from a resilient material.

24. Arrangement according to one of claims 16 to 23, characterised in that the wiping device comprises at least one wiping roller (15), the periphery of which is provided with the coating (31), in that a drive is provided for rotating at least one wiping roller, the direction of rotation and/or circumferential speed of which roller is selectable to produce a relative speed between the abutment location or abutment area of the wiping device and the surfaces of the printed circuit boards (8).

25. Arrangement according to claim 24, characterised in that the wiping roller or the wiping rollers (15) comprises or comprise a perforate, metallic tube (30) or an expanded metal tube or a wire grating tube and a cylindrical coating (31), which surrounds the wiping roller, the electrolyte being supplied or discharged internally of the tube, expanded metal or wire grating tube.

26. Arrangement according to claim 24, characterised in that the wiping roller or the wiping rollers comprises or comprise a metallic tube and a cylindrical coating (31), which surrounds the wiping roller, the coating and tube being held together by an expanded metal (32), situated therebetween, or by a wire grating, and in that the electrolyte is supplied from a location (33) externally of the wiping roller or wiping rollers to the bores (42) in the printed circuit boards (8).

27. Arrangement according to one of claims 24 to 26, characterised in that situated opposite a wiping roller (15), which abuts against a surface of the printed circuit boards and is provided with flow coating means, there is a pressure roller (64), which abuts against the other surface.

28. Arrangement according to claim 27, characterised in that, in the case of a two-sided galvanisation of the printed circuit boards, pairs of oppositely situated rollers are disposed one behind the other when viewed with respect to the direction of treatment (3), whereby, alternatively with one pair, a wiping roller (15) provided with flow-coating means is provided above the printed circuit boards (8) and a pressure roller (64) is provided beneath said printed circuit boards, and, in the case of the next pair, a wiping roller provided with flow-coating means is provided beneath the printed circuit boards and a pressure roller is provided above the printed circuit boards.

29. Arrangement according to one of claims 24 to 26, characterised in that at least one pair of wiping rollers are provided opposite one another, whereby one of the rollers is situated above the printed circuit boards (8) and the other roller is situated beneath said printed circuit boards, and the flow direction of the electrolyte is the same in both wiping rollers.

30. Arrangement according to one of claims 24 to 29, characterised in that the electrolyte is guided in the interior of the tube (30) of a wiping roller, and the electrolyte passes between the tube interior, the wall thereof and the coating (31) surrounding the tube.

31. Arrangement according to claim 30, characterised in that a number of through-apertures (34) are provided in the tube wall.

32. Arrangement according to one of claims 24 to 31, characterised in that, internally of the rotating tube (30) which is provided with through-apertures (34) for the electrolyte, a feed pipe (77), which guides the electrolyte, is provided with through-apertures or -slots (78), whereby the through-apertures or -slots (78) are orientated with their through-end faces towards the path of movement (2-3) of the printed circuit boards (8), and in that the feed pipe (77) as well as the rotating tube (30) extend over the entire width (a) of the path of the printed circuit boards.

33. Arrangement according to claim 32, characterised in that the through-apertures or -slots (78) of the feed pipe (77) are situated as close as possible to the printed circuit boards (8).

34. Arrangement according to claim 32 or 33, characterised in that the feed pipe (77) is mounted in a non-rotating manner in the tube (30).

35. Arrangement according to one of claims 32 to 34, characterised in that the rotating tube (30), together with the feed pipe (77) situated therein, is displaceably mounted substantially vertically relative to the plane of the printed circuit boards (8).

36. Arrangement according to one of claims 24 to 35, characterised in that one or more tubes (37) with apertures (36) for the electrolyte is or are provided for supplying the electrolyte to the spaces (38,39) between two wiping rollers (15), and in that collecting devices (40) for the electrolyte are provided beneath the spaces (38,39).

37. Arrangement according to one of claims 16 to 36, characterised in that pressure-producing means are provided for supplying the electrolyte to the bores (42) in the printed circuit boards.

38. Arrangement according to one of claims 16 to 37, characterised in that means are provided for sucking the electrolyte from the bores (42) in the printed circuit boards.

39. Arrangement according to claim 37 or 38, characterised in that a baffle nozzle (63) is provided for galvanising printed circuit boards (8), which are provided with bores (42), said nozzle urging the electrolyte through bores (42), which are situated in the region of the baffle nozzle aperture or slots (41), while the electrolyte is returned through other bores (42) in the edge region of the baffle nozzle by means of a reduced pressure on the underside of the printed circuit boards, the baffle nozzle extending over the entire width of the printed circuit boards (8) to be treated.

40. Arrangement according to claim 39, characterised in that anodes (48) are situated internally of the baffle nozzle (63), preferably internally of a preliminary chamber (68), which is surrounded by a housing and to which the electrolyte is supplied (65).

41. Arrangement according to claim 39 or 40, characterised in that a suction device (72) is situated on the outlet side of the bores (42), to which the electrolyte is supplied with pressure through the baffle nozzle (63), the housing (75) of said suction device being under reduced pressure and extending over the entire width (a) of the printed circuit boards to be treated.

42. Arrangement according to one of claims 16 to 35, 37 to 41, characterised in that lower tubes (37'), which convey the electrolyte upwardly from below, are provided with through-apertures (36').

43. Arrangement according to one of claims 16 to 42, characterised in that the wiping device or the wiping devices abut against the respective surfaces of the printed circuit boards with resilient force (23,55).

44. Arrangement according to one of claims 16 to 43, characterised in that the printed circuit boards (8) to be treated are placed and guided in a horizontal position in the treatment station.

45. Arrangement according to claim 44, characterised in that conveyor means (10), preferably clamps (9), are provided for the conveyance of the printed circuit boards in a horizontal position, such means gripping at least one of their lateral edges (8').

46. Arrangement according to one of claims 16 to 45, characterised in that the pressure rollers (51), which are situated opposite a wiping roller (15) in the form of a flow-coating roller (30,31,77,78), are provided with drainage grooves (52), which serve to conduct the electrolyte away.

47. Arrangement according to one of claims 16 to 45, characterised in that two counter-rollers (48) are mounted opposite the wiping and flow-coating roller (15;31,77,78) on the other side of the printed circuit boards and are so positioned that they form therebetween a throughflow chamber (60) for the electrolyte, such chamber either being urged by pressure from the flow-coating roller into the bores (42) in the printed circuit boards or being sucked into the flow-coating roller through the bores (42) by means of suction.

48. Arrangement according to one of claims 16 to 47, characterised in that the thickness of the coating (31) is relatively small, and is preferably 1-4 mm.

49. Arrangement according to one of claims 16 to 48, characterised in that various wiping devices are provided in combination with one another for the electrolytic treatment of the same printed circuit boards.

## Revendications

1. Procédé de traitement électrolytique de plaquettes de circuits imprimés munies de trous, lesquelles sont transportées par des moyens de transport à travers un bain de traitement ou vers une station de traitement, des moyens destinés à la réduction de l'épaisseur d'une zone pauvre en ions métalliques (couche de diffusion) étant prévus, lesquels sont en contact avec les plaquettes de circuits imprimés, en présence d'une anode et de plaquettes de circuits imprimés cathodiques (K), ou en présence de plaquettes de circuits imprimés anodiques et d'une cathode, les surfaces (K1) à traiter des plaquettes de circuits imprimés sont nettoyées en continu et par voie mécanique, et l'électrolyte est mis en mouvement avec une composante de mouvement sensiblement perpendiculaire au plan des plaquettes de circuits imprimés et traverse les trous (42) de ces dernières.

2. Procédé de traitement électrolytique de plaquettes de circuits imprimés munies de trous, lesquelles sont transportées par des moyens de transport à travers un bain de traitement ou vers une station de traitement, des moyens destinés à la réduction de l'épaisseur d'une zone pauvre en ions métalliques (couche de diffusion) étant prévus, lesquels sont en contact avec les plaquettes de circuits imprimés, il s'établit un mouvement relatif entre, d'une part, les plaquettes de circuits imprimés (8) cathodiques ou anodiques et, d'autre part, un dispositif de nettoyage mécanique (15 ; 46 ; 47; 53 ; 59), monté du côté anodique ou du côté cathodique, lequel est amené directement en contact mobile sur les surfaces des plaquettes de circuits imprimés, pour perturber ou du moins pour détruire partiellement la couche de diffusion, et l'électrolyte est mis en mouvement avec une composante de mouvement sensiblement perpendiculaire au plan des plaquettes de circuits imprimés et traverse les trous (42) de ces dernières.

3. Procédé selon la revendication 2, caractérisé en ce que le mouvement relatif susmentionné est créé par un mouvement de transport (2-3) des plaquettes de circuits imprimés (8) cathodiques ou anodiques vers le dispositif de nettoyage (15 ; 46 ; 47 ; 53 ; 59), monté du côté anodique ou du côté cathodique.

4. Procédé selon la revendication 2 ou 3, caractérisé en ce que le mouvement des plaquettes de circuits imprimés (8) cathodiques s'effectue par rapport au dispositif de nettoyage (15 ; 46 ; 47 ; 53 ; 59), monté du côté anodique, lequel est muni d'un revêtement (31 ; 54 ; 61) réalisé dans un matériau absorbant et laissant passer l'électrolyte, et en ce que le revêtement est mis directement en contact mobile sur les surfaces des plaquettes de circuits imprimés, pour perturber ou au moins pour réduire la couche de diffusion, tandis que pour réduire la couche de diffusion dans les trous des plaquettes de circuits imprimés l'électrolyte est en même temps mis en mouvement avec une composante de mouvement sensiblement perpendiculaire au plan des plaquettes de circuits imprimés et traverse les trous (42) de ces dernières.

5. Procédé selon l'une quelconque des revendications 1 à 4, caractérisé en ce que l'une des surfaces ou les deux surfaces des plaquettes de circuits imprimés sont nettoyées.

6. Procédé selon l'une quelconque des revendications 2 à 5, caractérisé en ce que le dispositif de nettoyage (15 ; 46 ; 47 ; 53 ; 59), monté du côté anodique, est animé, à son point de contact ou à sa surface de contact avec les surfaces des plaquettes de circuits imprimés (8), par un mouvement propre, qui diffère en valeur et/ou en direction du mouvement de transport.

7. Procédé selon l'une quelconque des revendications 1 à 6, caractérisé en ce que, en cas de traitement des deux surfaces des plaquettes de circuits imprimés (8), la vitesse relative de ces dernières par rapport au dispositif de nettoyage sur l'une des surfaces est orientée à l'inverse de la vitesse relative par rapport au dispositif de nettoyage sur l'autre surface.

8. Procédé selon l'une quelconque des revendications 2 à 6, caractérisé en ce que, en cas de traitement des deux surfaces des plaquettes de circuits imprimés (8), la vitesse relative de ces dernières par rapport au dispositif de nettoyage est orientée dans le même sens pour les deux surfaces.

9. Procédé selon l'une quelconque des revendications 2 à 8, caractérisé en ce que la vitesse relative entre les plaquettes de circuits imprimés et le dispositif de nettoyage est faible, en particulier, elle tend pratiquement vers zéro.

10. Procédé selon l'une quelconque des revendications 1 à 9, caractérisé en ce que le dispositif de nettoyage exerce une pression sur les plaquettes de circuits imprimés.

11. Procédé selon l'une quelconque des revendications 4 à 10, caractérisé en ce qu'en présence d'un revêtement élastique du dispositif de nettoyage, le revêtement est refoulé ou comprimé.

12. Procédé selon l'une quelconque des revendications 1 à 11, caractérisé en ce que pendant le mouvement (2-3) des plaquettes de circuits imprimés (8) dans la ligne de traitement, la densité du courant galvanique est augmentée.

13. Procédé selon l'une quelconque des revendications 1 à 12, caractérisé en ce que l'électrolyte est guidé sous pression à travers les trous (42).

14. Procédé selon l'une quelconque des revendications 1 à 13, caractérisé en ce que l'électrolyte est aspiré hors des trous (42) à l'aide d'une dépression.

15. Procédé selon l'une quelconque des revendications 1 à 14, caractérisé en ce que le nettoyage des surfaces et le passage de l'électrolyte par les trous s'effectue au-dessous du niveau du bain (25) et, de ce fait, à l'intérieur du liquide du bain.

16. Dispositif de traitement électrolytique de plaquettes de circuits imprimés munies de trous, lesquelles sont transportées par des moyens de transport à travers un bain de traitement ou vers une station de traitement, des moyens destinés à la réduction de l'épaisseur d'une zone pauvre en ions métalliques (couche de diffusion) étant prévus, lesquels sont en contact avec le matériau à traiter, destiné en particulier à la mise en oeuvre du procédé selon l'une ou plusieurs des revendications 1 à 15, dans lequel il est prévu de monter des moyens (W) pour le nettoyage de la surface ou des surfaces des plaquettes de circuits imprimés cathodiques (K) ou anodiques et, en outre, des moyens pour mettre en mouvement l'électrolyte dans un flux sensiblement perpendiculaire au plan des plaquettes de circuits imprimés (8), lequel traverse les trous (42) de ces dernières.

17. Dispositif selon la revendication 16, caractérisé en ce que, pour le dépôt de métal, le dispositif de nettoyage est monté sur l'anode.

18. Dispositif selon la revendication 16 ou 17, caractérisé en ce que le dispositif de nettoyage (15 ; 46 ; 47 ; 53 ; 59), monté du côté de l'anode ou du côté de la cathode, est revêtu d'un revêtement (31) et s'appuie contre les surfaces des plaquettes de circuits imprimés (8) cathodiques ou anodiques, au moins pendant un mouvement relatif entre les plaquettes de circuits imprimés et le dispositif de nettoyage.

19. Dispositif selon la revendication 18, caractérisé en ce que le dispositif de nettoyage ou plusieurs dispositifs de nettoyage s'étend ou s'étendent sur toute la largeur, orientée perpendiculairement à la direction de transport, ou sur la périphérie des plaquettes de circuits imprimés transportées, et les plaquettes de circuits imprimés peuvent être au moins déplacées par rapport à un dispositif de nettoyage.

20. Dispositif selon l'une quelconque des revendications 16 à 19, caractérisé en ce que le revêtement (31) s'appuie contre les surfaces des plaquettes de circuits imprimés (8) avec une force de pression réglable.

21. Dispositif selon l'une quelconque des revendications 16 à 20, caractérisé en ce que le revêtement (31) est réalisé dans un matériau résistant aux agressions chimiques de l'électrolyte, en particulier un matériau synthétique.

22. Dispositif selon la revendication 21, caractérisé en ce que le revêtement est réalisé dans un matériau synthétique à pores ouverts, qui est perméable au liquide et résiste à l'usure.

23. Dispositif selon la revendication 21 ou 22, caractérisé en ce que le revêtement (31) est réalisé dans un matériau élastique.

24. Dispositif selon l'une quelconque des revendications 16 à 23, caractérisé en ce que le dispositif de nettoyage comprend au moins un rouleau de nettoyage (15), dont la périphérie est revêtue du revêtement (31), en ce qu'il est prévu de monter un moteur pour la rotation d'au moins un rouleau de nettoyage, dont il est possible de régler le sens de rotation et/ou la vitesse de rotation pour produire une vitesse relative entre le point de contact ou la surface de contact du dispositif de nettoyage et les surfaces des plaquettes de circuits imprimés (8).

25. Dispositif selon la revendication 24, caractérisé en ce que le rouleau de nettoyage ou les rouleaux de nettoyage (15) sont constitués par un tube métallique troué (30) ou un tube de métal déployé ou un tube en treillis métallique et par un revêtement (31) cylindrique qui enveloppe le rouleau de nettoyage, l'admission et l'évacuation de l'électrolyte étant réalisées à l'intérieur du tube, du métal déployé ou du tube en treillis métallique.

26. Dispositif selon la revendication 24, caractérisé en ce que le rouleau de nettoyage ou les rouleaux de nettoyage sont constitués par un tube métallique et par un revêtement (31) cylindrique qui enveloppe le rouleau de nettoyage, le revêtement et le tube étant maintenus l'un contre l'autre par un métal déployé (32) ou un treillis métallique placé entre eux et en ce que l'électrolyte est introduit depuis un lieu (33) à l'extérieur du rouleau de nettoyage ou des rouleaux de nettoyage vers les trous (42) des plaquettes de circuits imprimés (8).

27. Dispositif selon l'une quelconque des revendications 24 à 26, caractérisé en ce qu'un rouleau de nettoyage (15) avec des moyens de mouillage, appuyé contre une surface des plaquettes de circuits imprimés, est situé face à un autre rouleau de pression (64) appuyé contre l'autre surface.

28. Dispositif selon la revendication 27, caractérisé en ce que, en cas de dépôt galvanique sur les deux surfaces des plaquettes de circuits imprimés, des paires formées de rouleaux placés face à face sont disposées l'une derrière l'autre dans le sens du traitement (3), cet ensemble étant constitué alternativement par une paire formée d'un rouleau de nettoyage (15) avec des moyens de mouillage, monté au-dessus et d'un rouleau de pression (64) monté au-dessous des plaquettes de circuits imprimés (8), puis par une paire formée d'un rouleau de nettoyage avec des moyens de mouillage, monté au-dessous des plaquettes de circuits imprimés, et d'un rouleau de pression monté au-dessus des plaquettes de circuits imprimés.

29. Dispositif selon l'une quelconque des revendications 24 à 26, caractérisé en ce qu'il est prévu de monter au moins une paire de rouleaux de nettoyage situés face à face, un rouleau étant monté au-dessus des plaquettes de circuits imprimés (8) et l'autre rouleau au-dessous, et le sens du flux de l'électrolyte est le même dans les deux rouleaux de nettoyage.

30. Dispositif selon l'une quelconque des revendications 24 à 29, caractérisé en ce que l'électrolyte passe à l'intérieur du tube (30) d'un rouleau de nettoyage et l'électrolyte passe entre l'intérieur du tube, les parois de ce dernier et le revêtement (31) qui enveloppe le tube.

31. Dispositif selon la revendication 30, caractérisé en ce qu'une série d'orifices de passage (34) est prévue dans la paroi du tube.

32. Dispositif selon l'une quelconque des revendications 24 à 31, caractérisé en ce qu'à l'intérieur du tube rotatif (30), muni d'orifices de passage (34) pour l'électrolyte, est monté un tube d'admission (77) de l'électrolyte muni d'orifices ou de fentes de passage (78), les orifices ou les fentes de passage (78) étant orientés avec leurs extrémités finales de passage vers la voie de déplacement (2-3) des plaquettes de circuits imprimés (8) et en ce que le tube d'admission (77), de même que le tube rotatif (30), s'étend sur toute la largeur (a) de la voie des plaquettes de circuits imprimés.

33. Dispositif selon la revendication 32, caractérisé en ce que les orifices ou les fentes de passage (78) du tube d'admission (77) sont situés le plus près possible des plaquettes de circuits imprimés (8).

34. Dispositif selon la revendication 32 ou 33, caractérisé en ce que le tube d'admission (77) est monté bloqué en rotation dans le tube (30).

35. Dispositif selon l'une quelconque des revendications 32 à 34, caractérisé en ce que le tube rotatif (30), conjointement avec le tube d'admission (77), placé à l'intérieur de ce dernier, est logé de manière à pouvoir se déplacer sensiblement perpendiculairement au plan des plaquettes de circuits imprimés (8).

36. Dispositif selon l'une quelconque des revendications 24 à 35, caractérisé en ce que l'introduction de l'électrolyte dans les espaces (38, 39) entre deux rouleaux de nettoyage (15) est effectué par l'intermédiaire d'un ou plusieurs tubes (37) munis d'orifices (36) pour l'électrolyte, et en ce que des dispositifs de réception (40) de l'électrolyte sont montés au-dessous des espaces (38, 39).

37. Dispositif selon l'une quelconque des revendications 16 à 36, caractérisé en ce que l'électrolyte est introduit dans les trous (42) des plaquettes de circuits imprimés par l'intermédiaire de moyens générateur de pression.

38. Dispositif selon l'une quelconque des revendications 16 à 37, caractérisé en ce que des moyens sont prévus pour aspirer l'électrolyte hors des trous (42) des plaquettes de circuits imprimés.

39. Dispositif selon la revendication 37 ou 38, caractérisé en ce qu'une buse d'injection (63) est prévue pour le dépôt galvanique sur les plaquettes de circuits imprimés (8) munies de trous (42), laquelle injecte l'électrolyte à travers les trous (42) situés dans la zone de l'orifice ou de la fente (41) de la buse d'injection, tandis que, dans la zone de bordure de la buse d'injection, l'électrolyte est reflué par d'autres trous (42) à l'aide d'une dépression qui règne sur la face inférieure des plaquettes de circuits imprimés, la buse d'injection s'étendant sur toute la largeur des plaquettes de circuits imprimés (8) à traiter.

40. Dispositif selon la revendication 39, caractérisé en ce que des anodes (48) sont situées à l'intérieur de la buse d'injection (63), et de préférence à l'intérieur d'un espace d'accès (68) fermé par un boîtier, dans lequel est introduit (65) l'électrolyte.

41. Dispositif selon la revendication 39 ou 40, caractérisé en ce que la face de sortie des trous (42), dans lesquels l'électrolyte est introduit sous pression par la buse d'injection (63), est munie d'un dispositif d'aspiration (72), dont le boîtier (75) mis en dépression s'étend sur toute la largeur (a) des plaquettes de circuits imprimés à traiter.

42. Dispositif selon l'une quelconque des revendications 16 à 35, 37 à 41, caractérisé en ce qu'il est prévu de monter des tubes inférieurs (37'), dans lesquels circule l'électrolyte du bas vers le haut, sur lesquels sont réalisés des orifices de passage (36').

43. Dispositif selon l'une quelconque des revendications 16 à 42, caractérisé en ce que le dispositif de nettoyage ou les dispositifs de nettoyage s'appuient sous l'action de ressorts (23, 55) contre chaque surface des plaquettes de circuits imprimés.

44. Dispositif selon l'une quelconque des revendications 16 à 43, caractérisé en ce que les plaquettes de circuits imprimés (8) à traiter sont déposées et guidées en position horizontale vers la station de traitement.

45. Dispositif selon la revendication 44, caractérisé en ce que le transport des plaquettes de circuits imprimés en position horizontale est assuré par au moins un moyen de transport (10) maintenant leurs faces latérales (8'), de préférence des brides de serrage (9).

46. Dispositif selon l'une quelconque des revendications 16 à 45, caractérisé en ce que les rouleaux de pression (51), utilisés comme rouleaux de mouillage (30, 31, 77, 78), situés face à un rouleau de nettoyage (15), sont munis de rainures de drainage (52), qui servent à évacuer l'électrolyte.

47. Dispositif selon l'une quelconque des revendications 16 à 45, caractérisé en ce que les rouleaux de nettoyage et les rouleaux de mouillage (15 ; 31, 77, 78) sont logés sur l'autre face des plaquettes de circuits imprimés, face à deux contre-rouleaux (48), et positionnés de telle sorte qu'ils forment entre eux un espace de passage (60) pour l'électrolyte, qui, sous l'effet de la pression provenant des rouleaux de mouillage, traverse les trous (42) des plaquettes de circuits imprimés, ou est aspiré à travers les trous (42) par aspiration dans le rouleau de mouillage.

48. Dispositif selon l'une quelconque des revendications 16 à 47, caractérisé en ce que l'épaisseur du revêtement (31) est relativement faible, de préférence 1 à 4 mm.

49. Dispositif selon l'une quelconque des revendications 16 à 48, caractérisé en ce qu'il est prévu de monter différents dispositifs de nettoyage combinés les uns aux autres pour le traitement électrolytique des mêmes plaquettes de circuits imprimés.
